# EUROPEAN PATENT APPLICATION

(11) **EP 4 586 780 A1**
(43) Date of publication of application: **16.07.2025**
(21) Application number: 23876545.7
(22) Date of filing: 27.09.2023
(51) Int. Cl.: H10K 59/00

(54) **PIXEL ARRANGEMENT STRUCTURE, ELECTRONIC DEVICE, DISPLAY PANEL AND PREPARATION METHOD**

(30) Priority: 10.10.2022 CN 202211235628
(71) Applicant: Huawei Technologies Co., Ltd., Shenzhen, Guangdong 518129 (CN)
(72) Inventor: TSURUMA, Takeyuki, Shenzhen, Guangdong 518129 (CN); SAKAIGAWA, Akira, Shenzhen, Guangdong 518129 (CN); ZHENG, Zhiwei, Shenzhen, Guangdong 518129 (CN)
(74) Representative: Grünecker Patent- und Rechtsanwälte PartG mbB
(86) International application number: PCT/CN2023/122144
(87) International publication number: WO 2024/078341

(57) **Abstract**

Embodiments of this application provide a pixel arrangement structure, an electronic device, a display panel, and a preparation method. The pixel arrangement structure includes sub-pixels arranged into a structure of N rows and M columns. A first sub-pixel row, a second sub-pixel row, and a third sub-pixel row are three adjacent rows of sub-pixels in N rows of sub-pixels, and the second sub-pixel row is located between the first sub-pixel row and the third sub-pixel row. A first sub-pixel, a second sub-pixel, and a third sub-pixel are three adjacent sub-pixels in the first sub-pixel row. A fourth sub-pixel, a fifth sub-pixel, and a sixth sub-pixel are three adjacent sub-pixels in the third sub-pixel row. A center of the first sub-pixel, a center of the second sub-pixel, a center of the third sub-pixel, a center of the fourth sub-pixel, a center of the fifth sub-pixel, and a center of the sixth sub-pixel form a virtual hexagon, and the virtual hexagon includes at least three obtuse angles and at least two acute angles. Display effect can be improved according to the foregoing technical solutions.

## Description

This application claims priority to Chinese Patent Application No. 202211235628.0, filed with the China National Intellectual Property Administration on October 10, 2022 and entitled "PIXEL ARRANGEMENT STRUCTURE, ELECTRONIC DEVICE, DISPLAY PANEL, AND PREPARATION METHOD", which is incorporated herein by reference in its entirety.

### TECHNICAL FIELD

Embodiments of this application relate to the field of display technologies, and more specifically, to a pixel arrangement structure, an electronic device, a display panel, and a preparation method.

### BACKGROUND

With development of technologies, users have increasingly high requirements on display apparatuses. Display technologies with self-luminous characteristics, such as an organic light-emitting diode (organic light-emitting diode, OLED) and an active-matrix organic light-emitting diode (active-matrix organic light-emitting diode, AMOLED), are increasingly applied to the display apparatuses because of characteristics such as high luminance and a high response speed.

The OLED is used as an example. A display panel of the OLED usually includes three types of sub-pixels: a sub-pixel used to transmit red light (which may be referred to as a red sub-pixel or an R sub-pixel for short), a sub-pixel used to transmit blue light (which may be referred to as a blue sub-pixel or a B sub-pixel for short), and a sub-pixel used to transmit green light (which may be referred to as a green sub-pixel or a G sub-pixel for short).

The sub-pixels are usually arranged in the display panel in a form of an array. Researchers find that factors such as an arrangement manner of the sub-pixels and sizes of the sub-pixels affect final display effect of the display panel.

### SUMMARY

Embodiments of this application provide a pixel arrangement structure, an electronic device, a display panel, and a preparation method, to improve display effect.

According to a first aspect, an embodiment of this application provides a pixel arrangement structure. The pixel arrangement structure includes sub-pixels arranged into a structure of N rows and M columns, and both N and M are positive integers greater than or equal to 3. A first sub-pixel row, a second sub-pixel row, and a third sub-pixel row are three adjacent rows of sub-pixels in N rows of sub-pixels, and the second sub-pixel row is located between the first sub-pixel row and the third sub-pixel row. A first sub-pixel, a second sub-pixel, and a third sub-pixel are three adjacent sub-pixels in the first sub-pixel row. A fourth sub-pixel, a fifth sub-pixel, and a sixth sub-pixel are three adjacent sub-pixels in the third sub-pixel row. The first sub-pixel and the fourth sub-pixel belong to a first sub-pixel column, the second sub-pixel and the fifth sub-pixel belong to a second sub-pixel column, the third sub-pixel and the sixth sub-pixel belong to a third sub-pixel column, the first sub-pixel column, the second sub-pixel column, and the third sub-pixel column are three columns of sub-pixels in M columns of sub-pixels, and the second sub-pixel column is located between the first sub-pixel column and the third sub-pixel column. A center of the first sub-pixel, a center of the second sub-pixel, a center of the third sub-pixel, a center of the fourth sub-pixel, a center of the fifth sub-pixel, and a center of the sixth sub-pixel form a virtual hexagon, and the virtual hexagon includes at least three obtuse angles and at least two acute angles.

In the foregoing technical solution, centers of six sub-pixels that are respectively located in two rows may form a hexagon. In other words, centers of the sub-pixels in the same row are not on the same line. Therefore, in this arrangement manner, distances between central points of a sub-pixel in the first sub-pixel row and a sub-pixel in the third sub-pixel row and a central point of a sub-pixel in the second sub-pixel row may be shortened. At a same deviation angle, a sub-pixel offset can be reduced according to the foregoing technical solutions. This reduces impact of a photomask alignment deviation on an actual pixel offset, improves edge chromatic aberration and sawtooth sense of display effect, and reduces diffraction effect.

With reference to the first aspect, in a possible implementation of the first aspect, the first sub-pixel, the second sub-pixel, the third sub-pixel, the fourth sub-pixel, the fifth sub-pixel, and the sixth sub-pixel are configured to emit light of a first color.

In the foregoing technical solution, sub-pixels of the same attribute are not located on a same straight line. Therefore, strength of the moire can be dispersed. This reduces the strength of the moire.

With reference to the first aspect, in a possible implementation of the first aspect, a side length of a first side of the virtual hexagon is equal to a side length of a second side of the virtual hexagon, a side length of a third side of the virtual hexagon is equal to a side length of a fourth side of the virtual hexagon, endpoints of the first side are the center of the first sub-pixel and the center of the second sub-pixel, endpoints of the second side are the center of the second sub-pixel and the center of the third sub-pixel, endpoints of the third side are the center of the fourth sub-pixel and the center of the fifth sub-pixel, and endpoints of the fourth side are the center of the fifth sub-pixel and the center of the sixth sub-pixel.

With reference to the first aspect, in a possible implementation of the first aspect, the second sub-pixel row includes a seventh sub-pixel and an eighth sub-pixel, a distance between a center of the seventh sub-pixel and a center of a first virtual quadrilateral is less than a first threshold, and the first virtual quadrilateral includes the center of the first sub-pixel, the center of the second sub-pixel, the center of the fourth sub-pixel, and the center of the fifth sub-pixel; and a distance between a center of the eighth sub-pixel and a center of a second virtual quadrilateral is greater than a second threshold, and the second virtual quadrilateral includes the center of the second sub-pixel, the center of the third sub-pixel, the center of the fifth sub-pixel, and the center of the sixth sub-pixel.

With reference to the first aspect, in a possible implementation of the first aspect, a distance between the center of the eighth sub-pixel and a long diagonal of the second virtual quadrilateral is less than a third threshold.

With reference to the first aspect, in a possible implementation of the first aspect, the seventh sub-pixel is configured to emit light of a second color, and the eighth sub-pixel is configured to emit light of a third color.

With reference to the first aspect, in a possible implementation of the first aspect, the first sub-pixel, the third sub-pixel, and the fifth sub-pixel are configured to emit light of a second color; and the second sub-pixel, the fourth sub-pixel, and the sixth sub-pixel are configured to emit light of a third color.

In the foregoing technical solution, sub-pixels of the same attribute are not located on a same straight line. Therefore, strength of the moire can be dispersed. This reduces the strength of the moire.

With reference to the first aspect, in a possible implementation of the first aspect, the at least two acute angles include acute angles greater than or equal to 80 degrees and less than or equal to 88 degrees.

With reference to the first aspect, in a possible implementation of the first aspect, the first color is green.

With reference to the first aspect, in a possible implementation of the first aspect, the second color is blue, and the third pixel is red.

With reference to the first aspect, in a possible implementation of the first aspect, an area of a pixel configured to emit blue light is greater than an area of a pixel configured to emit red light, and the area of the pixel configured to emit blue light is greater than an area of a pixel configured to emit green light.

A current applied to a sub-pixel is inversely proportional to an area of the sub-pixel. In other words, the larger the area, the smaller the current required to maintain the same luminance, the smaller the corresponding power consumption, and the better the service life and reliability. Currently, in a case of a same area, compared with sub-pixels that emit red light and green light, a sub-pixel that emits blue light has relatively low service life and reliability. Therefore, increasing an area of the blue photon pixel can improve service life and reliability of the sub-pixel. This improves an overall service life and reliability of the display panel. In addition, a larger sub-pixel area indicates a larger aperture ratio. Therefore, an aperture ratio of a sub-pixel that emits blue light may be further improved according to the foregoing technical solutions.

With reference to the first aspect, in a possible implementation of the first aspect, a shape of each sub-pixel in the pixel arrangement structure is a polygon, an ellipse, a circle, or a rounded polygon.

With reference to the first aspect, in a possible implementation of the first aspect, the N rows of sub-pixels further include a fourth sub-pixel row, and the fourth sub-pixel row is adjacent to the third sub-pixel row. A ninth sub-pixel, a tenth sub-pixel, and an eleventh sub-pixel are three adjacent sub-pixels in the second sub-pixel row, and a twelfth sub-pixel, a thirteenth sub-pixel, and a fourteenth sub-pixel are three adjacent sub-pixels in the fourth sub-pixel row. The ninth sub-pixel and the twelfth sub-pixel belong to a fourth sub-pixel column, the tenth sub-pixel and the thirteenth sub-pixel belong to a fifth sub-pixel column, and the eleventh sub-pixel and the fourteenth sub-pixel belong to a sixth sub-pixel column. The fourth sub-pixel column, the fifth sub-pixel column, and the sixth sub-pixel column are three columns of sub-pixels in the M sub-pixel columns, and the fifth sub-pixel column is located between the fourth sub-pixel column and the sixth sub-pixel column. A center of the ninth sub-pixel, a center of the tenth sub-pixel, a center of the eleventh sub-pixel, a center of the twelfth sub-pixel, a center of the thirteenth sub-pixel, and a center of the fourteenth sub-pixel form a virtual hexagon, and the virtual hexagon includes at least three obtuse angles and at least two acute angles.

With reference to the first aspect, in a possible implementation of the first aspect, when the first sub-pixel, the second sub-pixel, the third sub-pixel, the fourth sub-pixel, the fifth sub-pixel, and the sixth sub-pixel are configured to emit light of a first color, the ninth sub-pixel, the eleventh sub-pixel, and the thirteenth sub-pixel are configured to emit light of a second color, and the tenth sub-pixel, the twelfth sub-pixel, and the fourteenth sub-pixel are configured to emit light of a third color.

With reference to the first aspect, in a possible implementation of the first aspect, when the first sub-pixel, the third sub-pixel, and the fifth sub-pixel are configured to emit light of a second color, and the second sub-pixel, the fourth sub-pixel, and the sixth sub-pixel are configured to emit light of a third color, the ninth sub-pixel, the tenth sub-pixel, the eleventh sub-pixel, the twelfth sub-pixel, the thirteenth sub-pixel, and the fourteenth sub-pixel are configured to emit light of a first color.

A hexagon consisting of centers of the first sub-pixel, the second sub-pixel, the third sub-pixel, the fourth sub-pixel, the fifth sub-pixel, and the sixth sub-pixel may be referred to as a first hexagon. A hexagon consisting of centers of the ninth sub-pixel, the tenth sub-pixel, the eleventh sub-pixel, the twelfth sub-pixel, the thirteenth sub-pixel, and the fourteenth sub-pixel may be referred to as a second hexagon.

With reference to the first aspect, in a possible implementation of the first aspect, when the ninth sub-pixel, the tenth sub-pixel, the eleventh sub-pixel, the twelfth sub-pixel, the thirteenth sub-pixel, and the fourteenth sub-pixel are configured to emit light of the first color, a fifth side and a sixth side of the second hexagon are equal, a seventh side and an eighth side are equal, and two endpoints of the fifth side are centers of the ninth sub-pixel and the tenth sub-pixel respectively, the two endpoints of the sixth side are centers of the tenth sub-pixel and the eleventh sub-pixel respectively. Two endpoints of the seventh side are centers of the twelfth sub-pixel and the thirteenth sub-pixel respectively, and two endpoints of the eighth side are centers of the thirteenth sub-pixel and the fourteenth sub-pixel respectively.

With reference to the first aspect, in a possible implementation of the first aspect, when the ninth sub-pixel, the tenth sub-pixel, the eleventh sub-pixel, the twelfth sub-pixel, the thirteenth sub-pixel, and the fourteenth sub-pixel are configured to emit light of the first color, the third sub-pixel row includes a fifteenth sub-pixel and a sixteenth sub-pixel, and a distance between a center of the fifteenth sub-pixel and a center of a third virtual quadrilateral is less than a first threshold, the third virtual quadrilateral includes the center of the ninth sub-pixel, the center of the tenth sub-pixel, the center of the twelfth sub-pixel, and the center of the thirteenth sub-pixel. A distance between a center of the sixteenth sub-pixel and a center of a fourth virtual quadrilateral is greater than a second threshold, and the fourth virtual quadrilateral includes the center of the tenth sub-pixel, the center of the eleventh sub-pixel, the center of the thirteenth sub-pixel, and the center of the fourteenth sub-pixel.

With reference to the first aspect, in a possible implementation of the first aspect, a distance between the center of the sixteenth sub-pixel and a long diagonal of the fourth virtual quadrilateral is less than a third threshold.

With reference to the first aspect, in a possible implementation of the first aspect, the fifteenth sub-pixel is configured to emit light of the second color, and the sixteenth sub-pixel is configured to emit light of a third color.

According to a second aspect, an embodiment of this application provides a pixel arrangement structure. The pixel arrangement structure includes sub-pixels arranged into a structure of N rows and M columns, and both N and M are positive integers greater than or equal to 3. N rows of sub-pixels include a first sub-pixel row and a second sub-pixel row, and the first sub-pixel row and the second sub-pixel row are two adjacent rows of sub-pixels in the N rows of sub-pixels. P₁ groups of sub-pixels are arranged in the first sub-pixel row, each group of sub-pixels in the P₁ groups of sub-pixels includes multiple first sub-pixels, the P₁ groups of sub-pixels one-to-one correspond to P₁ virtual straight lines, centers of the multiple first sub-pixels included in each group of sub-pixels in the P₁ groups of sub-pixels are located on a corresponding virtual straight line, any two virtual straight lines in the P₁ virtual straight lines are parallel, and P₁ is a positive integer greater than or equal to 2. A second sub-pixel and a third sub-pixel are alternately arranged in the second sub-pixel row.

For example, the first sub-pixel row includes two groups of sub-pixels, and each group of sub-pixels in the two groups of sub-pixels includes multiple first sub-pixels. Any two adjacent first sub-pixels in the first sub-pixel row respectively belong to two groups of sub-pixels. In this case, centers of any two adjacent sub-pixels in the first sub-pixel row are respectively located on two different virtual straight lines. The two virtual straight lines may be respectively referred to as a first virtual straight line and a second virtual straight line, the first virtual straight line is parallel to the second virtual straight line, and a distance between the first virtual straight line and the second virtual straight line is greater than 0.

In the foregoing technical solution, the first sub-pixels are arranged in an offset manner, that is, centers of first sub-pixels in a same row are not in a same straight line. In this arrangement manner, a distance between a central point of the first sub-pixel and a central point of the second sub-pixel may be shortened. In this way, at a same deviation angle, a sub-pixel offset can be reduced according to the foregoing technical solutions. This reduces impact of a photomask alignment deviation on an actual pixel offset, improves edge chromatic aberration and sawtooth sense of display effect, and reduces diffraction effect.

With reference to the second aspect, in a possible implementation of the second aspect, the second sub-pixel row includes P₂ groups of sub-pixels, each group of sub-pixels in the P₁ groups of sub-pixels includes multiple sub-pixels, the P₂ groups of sub-pixels one-to-one correspond to P₂ virtual straight lines, centers of the multiple sub-pixels included in each group of sub-pixels in the P₂ groups of sub-pixels are located on a corresponding virtual straight line, any two virtual straight lines in the P₂ virtual straight lines are parallel, and P₂ is a positive integer greater than or equal to 2.

For example, the second sub-pixel row includes two groups of sub-pixels. In the two groups of sub-pixels, one group of sub-pixels includes multiple second sub-pixels, and the other group of sub-pixels includes multiple third sub-pixels. Any two adjacent sub-pixels in the second sub-pixel row respectively belong to two groups of sub-pixels. In this case, centers of any two adjacent sub-pixels in the second sub-pixel row are respectively located on two different virtual straight lines. The two virtual straight lines may be respectively referred to as a third virtual straight line and a fourth virtual straight line, the third virtual straight line is parallel to the fourth virtual straight line, and a distance between the third virtual straight line and the fourth virtual straight line is greater than 0.

In the foregoing technical solution, sub-pixels of the same attribute are not located on a same straight line. Therefore, four different unit arrangements are formed again. After the fast Fourier transform (fast Fourier transform, FFT) is spread, the four different unit arrangements correspond to four different frequencies, and strength of the moire is scattered on two different frequencies. In this way, the moire strength can be reduced.

With reference to the second aspect, in a possible implementation of the second aspect, the N rows of sub-pixels further include a third sub-pixel row, the first sub-pixel row, the second sub-pixel row, and the third sub-pixel row are three adjacent rows of sub-pixels in the N rows of sub-pixels, and the second sub-pixel row is located between the first sub-pixel row and the third sub-pixel row. Multiple first sub-pixels are arranged in the third sub-pixel row, P₃ groups of sub-pixels are arranged in the third sub-pixel row, each group of sub-pixels in the P₃ groups of sub-pixels includes multiple first sub-pixels, the P₃ groups of sub-pixels one-to-one correspond to P₃ virtual straight lines, centers of the multiple first sub-pixels included in each group of sub-pixels in the P₃ groups of sub-pixels are located on a corresponding virtual straight line, any two virtual straight lines in the P₃ virtual straight lines are parallel, and P₃ is a positive integer greater than or equal to 2. A center of a first target sub-pixel and a center of a second target sub-pixel are respectively located on two parallel virtual straight lines, where the first target sub-pixel is a sub-pixel in the first sub-pixel row, the second target sub-pixel is a sub-pixel in the third sub-pixel row, the first target sub-pixel and the second target sub-pixel belong to a first sub-pixel column, and the first sub-pixel column is one column of sub-pixels in M columns of sub-pixels.

For example, the third sub-pixel row includes two groups of sub-pixels, and each group of sub-pixels in the two groups of sub-pixels includes multiple first sub-pixels. Any two adjacent first sub-pixels in the third sub-pixel row respectively belong to two groups of sub-pixels. In this case, centers of any two adjacent sub-pixels in the third sub-pixel row are respectively located on two different virtual straight lines. The two virtual straight lines may be respectively referred to as a fifth virtual straight line and a sixth virtual straight line, the fifth virtual straight line is parallel to the sixth virtual straight line, and a distance between the fifth virtual straight line and the sixth virtual straight line is greater than 0.

With reference to the second aspect, in a possible implementation of the second aspect, a connection line of a center of a third target sub-pixel, a center of a fourth target sub-pixel, the center of the first target sub-pixel, and the center of the second target sub-pixel forms a first quadrilateral, the first quadrilateral is a parallel quadrilateral, the third target pixel is a sub-pixel that is adjacent to the first target sub-pixel and that is in the first sub-pixel row, the fourth target sub-pixel is a sub-pixel that is adjacent to the second target sub-pixel and that is in the third sub-pixel row, the third target pixel and the fourth target pixel belong to a second sub-pixel column, and the second sub-pixel column and the first sub-pixel column are two columns of sub-pixels in the M columns of sub-pixels.

With reference to the second aspect, in a possible implementation of the second aspect, an acute angle in internal angles of the first quadrilateral is greater than or equal to 80 degrees and less than or equal to 88 degrees.

With reference to the second aspect, in a possible implementation of the second aspect, the first quadrilateral includes a fifth target sub-pixel, and the fifth target sub-pixel is a sub-pixel in the second sub-pixel row. When the fifth target sub-pixel is the second sub-pixel, a distance between coordinates of a center of the fifth target sub-pixel and a center of the first parallel quadrilateral is less than a first threshold; or when the fifth target sub-pixel is the third sub-pixel, a distance between coordinates of a center of the fifth target sub-pixel and a center of the first parallel quadrilateral is greater than a second threshold.

With reference to the second aspect, in a possible implementation of the second aspect, when the fifth target sub-pixel is the third sub-pixel, a distance between the center of the fifth target sub-pixel and a long diagonal of the first quadrilateral is less than a third threshold.

With reference to the second aspect, in a possible implementation of the second aspect, the N rows of sub-pixels further include a fourth sub-pixel row, the first sub-pixel row, the second sub-pixel row, and the fourth sub-pixel row are three adjacent rows of sub-pixels in the N rows of sub-pixels, and the first sub-pixel row is located between the second sub-pixel row and the fourth sub-pixel row. The second sub-pixel and the third sub-pixel are alternately arranged in the fourth sub-pixel row. A connection line of a center of a sixth target sub-pixel, a center of a seventh target sub-pixel, a center of an eighth target sub-pixel, and a center of a ninth target sub-pixel forms a second quadrilateral. The second quadrilateral is a non-parallel quadrilateral. The sixth target sub-pixel and the seventh target sub-pixel are two adjacent sub-pixels in the second sub-pixel row. The eighth target sub-pixel and the ninth target sub-pixel are two adjacent sub-pixels in the fourth sub-pixel row. The sixth target sub-pixel and the eighth target sub-pixel belong to a third sub-pixel column. The seventh target sub-pixel and the ninth target sub-pixel belong to a fourth sub-pixel column. The third sub-pixel column and the fourth sub-pixel column are two columns of sub-pixels in the M columns of sub-pixels.

With reference to the second aspect, in a possible implementation of the second aspect, the center of the sixth target sub-pixel, the center of the seventh target sub-pixel, a center of a tenth target sub-pixel, and a center of an eleventh target sub-pixel form a third quadrilateral. The third quadrilateral is a parallel quadrilateral. The sixth target sub-pixel, the seventh target sub-pixel, and the tenth target sub-pixel are three adjacent sub-pixels in the second sub-pixel row. The eighth target sub-pixel, the ninth target sub-pixel, and the eleventh target sub-pixel are three adjacent sub-pixels in the fourth sub-pixel row. The tenth target sub-pixel and the eleventh target sub-pixel belong to a fifth sub-pixel column. The third sub-pixel column, the fourth sub-pixel column, and the fifth sub-pixel column are three columns of sub-pixels in the M columns of sub-pixels, and the fourth sub-pixel column is located between the third sub-pixel column and the fifth sub-pixel column.

With reference to the second aspect, in a possible implementation of the second aspect, an area of the second sub-pixel is greater than an area of the first sub-pixel, and the area of the second sub-pixel is greater than an area of the third sub-pixel.

A current applied to a sub-pixel is inversely proportional to an area of the sub-pixel. In other words, the larger the area, the smaller the current required to maintain the same luminance, the smaller the corresponding power consumption, and the better the service life and reliability. In this way, in the foregoing technical solution, an area of the second sub-pixel is increased, so that a current of maintaining same luminance for the second sub-pixel can be reduced. This reduces power consumption of the second sub-pixel, and improves service life and reliability of the second sub-pixel. In addition, a larger sub-pixel area indicates a larger aperture ratio. Therefore, an aperture ratio of the second sub-pixel can be further improved according to the foregoing technical solutions.

With reference to the second aspect, in a possible implementation of the second aspect, the first sub-pixel, the second sub-pixel, and the third sub-pixel are configured to emit light of different colors.

With reference to the second aspect, in a possible implementation of the second aspect, the first sub-pixel is configured to emit green light, the second sub-pixel is configured to emit blue light, and the third sub-pixel is configured to emit red light.

Currently, in a case of a same area, compared with sub-pixels that emit red light and green light, a sub-pixel that emits blue light has relatively low service life and reliability. Therefore, a sub-pixel with a largest area is configured to emit blue light can improve service life and reliability of the sub-pixel. This improves an overall service life and reliability of the display panel.

With reference to the second aspect, in a possible implementation of the second aspect, a shape of the first sub-pixel is a polygon, an ellipse, a circle, or a rounded polygon; a shape of the second sub-pixel is the polygon, the ellipse, the circle, or the rounded polygon; and a shape of the third sub-pixel is the polygon, the ellipse, the circle, or the rounded polygon.

According to a third aspect, an embodiment of this application provides a display panel. The display panel includes the pixel arrangement structure according to any one of the first aspect or the possible implementations of the first aspect.

According to a fourth aspect, an embodiment of this application provides an electronic device. The electronic device includes the display panel according to the third aspect.

According to a fifth aspect, an embodiment of this application provides a display panel. The display panel includes the pixel arrangement structure according to any one of the second aspect or the possible implementations of the second aspect.

According to a sixth aspect, an embodiment of this application provides an electronic device. The electronic device includes the display panel according to the fifth aspect.

According to a seventh aspect, an embodiment of this application further provides a preparation method for a display panel. The method includes: setting multiple sub-pixels on a substrate, where the multiple sub-pixels have the pixel arrangement structure according to any one of the first aspect or the possible implementations of the first aspect.

According to an eighth aspect, an embodiment of this application further provides a preparation method for a display panel. The method includes: setting multiple sub-pixels on a substrate, where the multiple sub-pixels have the pixel arrangement structure according to any one of the second aspect or the possible implementations of the second aspect.

### BRIEF DESCRIPTION OF DRAWINGS

FIG. 1 is a block diagram of a structure of a terminal device according to an embodiment of this application;
FIG. 2 is a diagram of a pixel arrangement structure according to an embodiment of this application;
FIG. 3 is a diagram of a relationship between two quadrilaterals and pixels in the two quadrilaterals;
FIG. 4 is a diagram of another pixel arrangement structure according to an embodiment of this application;
FIG. 5 is a diagram of a relationship between two quadrilaterals consisting of sub-pixels x in the pixel arrangement structure shown in FIG. 4 and sub-pixels in the quadrilateral;
FIG. 6 is a diagram of another pixel arrangement structure according to an embodiment of this application; and
FIG. 7 is a diagram of a virtual hexagon consisting of centers of sub-pixels according to an embodiment of this application.

### DESCRIPTION OF EMBODIMENTS

The following describes technical solutions of embodiments in this application with reference to accompanying drawings.

Embodiments of this application may be applied to a display panel that uses a self-luminous display technology, for example, an OLED or an AMOLED. Therefore, a display panel in embodiments of this application is the display panel that uses the self-luminous display technology, for example, the OLED or the AMOLED.

An electronic device in embodiments of this application may be a terminal device, a display device, or another electronic device including the display panel that uses the self-luminous display technology. For example, the terminal device may be a mobile phone, a notebook computer, or a tablet computer, and the display device may be a display, or an electronic billboard.

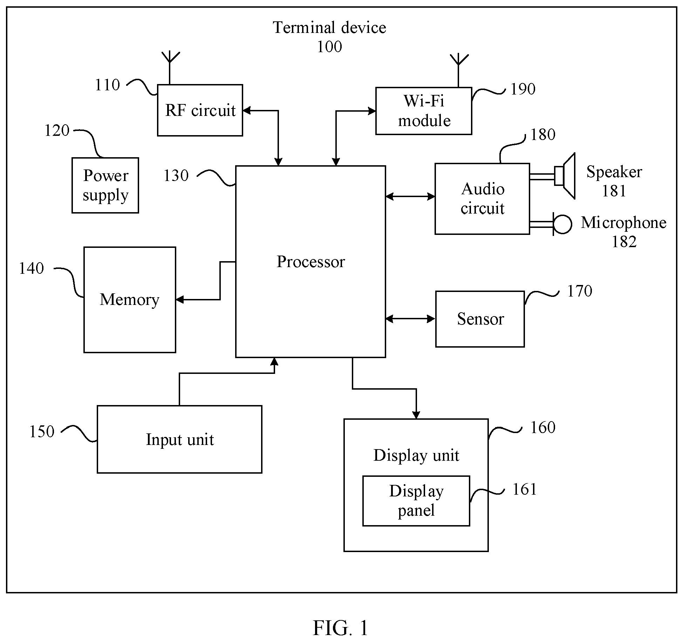

FIG. 1 is a block diagram of a structure of a terminal device according to an embodiment of this application. The terminal device 100 shown in FIG. 1 includes components such as a radio frequency (radio frequency, RF) circuit 110, a power supply 120, a processor 130, a memory 140, an input unit 150, a display unit 160, a sensor 170, an audio circuit 180, and a wireless fidelity (wireless fidelity, Wi-Fi) module 190. It may be understood by a person skilled in the art that, the structure of the terminal device shown in FIG. 1 does not constitute a limitation on the terminal device, and the terminal device may include more or fewer components than those shown in the figure, or a combination of a part of the components, or an arrangement of different components.

The following specifically describes each constituent component of the terminal device 100 in detail with reference to FIG. 1.

The RF circuit 110 may be configured to receive/send information or receive/send a signal during a call. Particularly, the RF circuit receives downlink information from a base station, then delivers the downlink information to the processor 130 for processing, and sends related uplink data to the base station. Usually, the RF circuit includes but is not limited to an antenna, at least one amplifier, a transceiver, a coupler, a low noise amplifier (low noise amplifier, LNA), and a duplexer. In addition, the RF circuit 110 may further communicate with a network and another device through wireless communication. The wireless communication may use any communication standard or protocol, including but not limited to a long term evolution (long term evolution, LTE) system, an LTE frequency division duplex (frequency division duplex, FDD) system, an LTE time division duplex (time division duplex, TDD) system, a universal mobile telecommunications system (universal mobile telecommunications system, UMTS), a worldwide interoperability for microwave access (worldwide interoperability for microwave access, Wi-MAX) communication system, a 5th generation (5^{th} generation, 5G) system or a new radio (new radio, NR) system, a future 6th generation (6th generation, 6G) system, non-terrestrial communication network (non-terrestrial network, NTN) systems such as an inter-satellite communication system and a satellite communication system, email, and a short message service (Short Message Service, SMS)

The memory 140 may be configured to store a software program and a module, and the processor 130 performs various function applications of the terminal device 100 and data processing by running the software program and the module stored in the memory 140. The memory 140 may mainly include a program storage area and a data storage area. The program storage area may store an operating system, an application required by at least one function (for example, a sound play function or an image play function), and the like. The data storage area may store data (such as audio data or a phone book) created according to use of the terminal device 100, and the like. In addition, the memory 140 may include a high-speed random access memory, or may include a nonvolatile memory, for example, at least one magnetic disk storage device, a flash storage device, or another volatile solid-state storage device.

The input unit 150 may be configured to: receive entered digital or character information, and generate a key signal input related to user setting and function control of the terminal device 100. The input unit 150 may include one or more of a touch panel, a physical keyboard, a function key (for example, a volume control key or an on/off key), a trackball, a mouse, a joystick, and the like.

The display unit 160 may be configured to display information entered by the user or information provided for the user, and various menus of the terminal device 100. The display unit 160 may include a display panel 161. The display panel 161 may be the display panel that uses the self-luminous display technology, for example, the OLED or the AMOLED.

The terminal device 100 may further include at least one sensor 170, for example, a light sensor, a motion sensor, and another sensor. Specifically, the light sensor may include an ambient light sensor and a proximity sensor, where the ambient light sensor may adjust luminance of the display panel 161 based on luminance of ambient light, and the proximity sensor may turn off the display panel 161 and/or backlight when the terminal device 100 moves close to an car. As a type of motion sensor, an acceleration sensor can detect a value of an acceleration in each direction (generally three axes), and detect a value and a direction of gravity when the acceleration sensor is static, and is applicable to an application for recognizing a terminal device posture (for example, switching between a landscape screen and a portrait screen, related games, and magnetometer posture calibration), a function related to vibration recognition (for example, a pedometer or a knock), and the like. Other sensors such as a gyroscope, a barometer, a hygrometer, a thermometer, and an infrared sensor may further be disposed on the terminal device 100. Details are not described herein.

The audio circuit 180, a speaker 181, and a microphone 182 may provide an audio interface between the user and the terminal device 100. The audio circuit 180 may transmit, to the speaker 181, an electrical signal converted from received audio data. The speaker 181 converts the electrical signal into an audio signal and outputs the audio signal. In addition, the microphone 182 converts the collected audio signal into an electrical signal. The audio circuit 180 receives the electrical signal, converts the electrical signal into audio data, and then outputs the audio data to the RF circuit 110, to send the audio data to another terminal device, or outputs the audio data to the memory 140 for further processing.

The terminal device 100 may help, by using a Wi-Fi module 190, a user receive/send an e-mail, browse a web page, access streaming media, and the like. The Wi-Fi module 190 provides wireless broadband internet access for the user. Although FIG. 1 shows the Wi-Fi module 190, it may be understood that the Wi-Fi module 190 does not belong to a necessary component of the terminal device 100 and may be omitted based on a requirement, without changing the scope of essence of the present invention.

The processor 130 is a control center of the terminal device 100, connects to various parts of the entire terminal device through various interfaces and lines, and performs various functions of the terminal device 100 and data processing by running or executing the software program and/or the module stored in the memory 140 and invoking data stored in the memory 140, to implement multiple services based on the terminal device. Optionally, the processor 130 may include one or more processing units. Preferably, the processor 130 may integrate an application processor and a modem processor. The application processor mainly processes an operating system, a user interface, an application, and the like. The modem processor mainly processes wireless communication. It may be understood that the foregoing modem processor may be not integrated into the processor 130.

The terminal device 100 further includes the power supply 120 (for example, a battery) that supplies power to each component. Preferably, the power supply may be logically connected to the processor 130 through a power management system, to implement functions such as charging, discharging, and power consumption management through the power management system.

Although not shown, the terminal device 100 may further include a camera, a Bluetooth module, and the like. Details are not described herein.

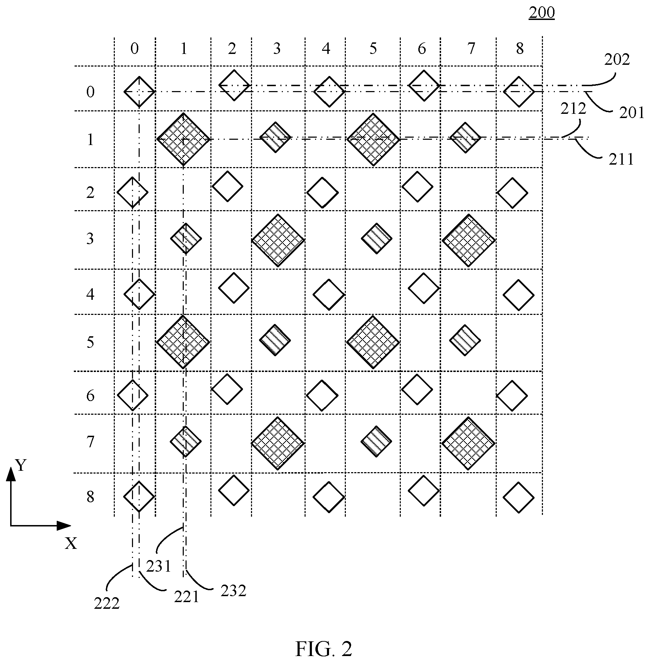

FIG. 2 is a diagram of a pixel arrangement structure according to an embodiment of this application. It may be understood that the pixel arrangement structure shown in FIG. 2 is a pixel arrangement structure consisting of a part of pixels included in a display panel.

The pixel arrangement structure 200 shown in FIG. 2 includes nine rows and nine columns of sub-pixels. For ease of description, the nine rows of sub-pixels may be respectively referred to as a sub-pixel row 0 to a sub-pixel row 8, and the nine columns of sub-pixels may be respectively referred to as a sub-pixel column 0 to a sub-pixel column 8. A sub-pixel located in a sub-pixel row x and a sub-pixel column y may be referred to as a sub-pixel xy, where x and y are positive integers greater than or equal to 0 and less than or equal to 8. For example, a sub-pixel located in the sub-pixel row 0 and a sub-pixel column 6 may be referred to as a sub-pixel 06, a sub-pixel located in the sub-pixel row 7 and the sub-pixel column 1 may be referred to as a sub-pixel 71, and the rest may be deduced by analogy.

As shown in FIG. 2, sub-pixels set in the sub-pixel row 0, the sub-pixel row 2, the sub-pixel row 4, the sub-pixel row 6, and the sub-pixel row 8 emit light of a same color. The sub-pixel row 1, the sub-pixel row 3, the sub-pixel row 5, and the sub-pixel row 7 are alternately set with sub-pixels that emit light of different colors. Correspondingly, colors of light emitted by the sub-pixels set in the sub-pixel column 0, the sub-pixel column 2, the sub-pixel column 4, the sub-pixel column 6, and the sub-pixel column 8 are the same. The sub-pixel column 1, the sub-pixel column 3, the sub-pixel column 5, and the sub-pixel column 7 are alternately set with sub-pixels that emit light of different colors. For ease of description, a sub-pixel set in the sub-pixel row 0, the sub-pixel row 2, the sub-pixel row 4, the sub-pixel row 6, or the sub-pixel row 8 may be referred to as a sub-pixel x, and a sub-pixel set in the sub-pixel row 1, the sub-pixel row 3, the sub-pixel row 5, or the sub-pixel row 7 may be referred to as a sub-pixel y or a sub-pixel z. For example, a sub-pixel 11 and a sub-pixel 15 in the sub-pixel row 1 are sub-pixels y, and a sub-pixel 13 and a sub-pixel 17 in the sub-pixel row 1 are sub-pixels z.

In some embodiments, light emitted by the sub-pixel x is green, light emitted by the sub-pixel y is blue, and light emitted by the sub-pixel z is red. In other words, the sub-pixel x is an R sub-pixel, the sub-pixel y is a B sub-pixel, and the sub-pixel z is a G sub-pixel. It may be understood that, in some other embodiments, the sub-pixel x, the sub-pixel y, and the sub-pixel z may alternatively have different configurations. For example, the sub-pixel x is a B sub-pixel, the sub-pixel y is an R sub-pixel, and the sub-pixel z is a G sub-pixel. For another example, the sub-pixel x is an R sub-pixel, the sub-pixel y is a B sub-pixel, and the sub-pixel z is a G sub-pixel.

Based on different types of set sub-pixels, the nine sub-pixel rows shown in FIG. 2 may include two types of sub-pixel rows. All sub-pixels in a first-type sub-pixel row are sub-pixels x, and sub-pixels y and sub-pixels z are alternately set in a second-type sub-pixel row. Correspondingly, the sub-pixel columns may also be classified into two types. All sub-pixels set in a first-type sub-pixel column are sub-pixels x, and sub-pixels y and sub-pixels z are alternately set in a second-type sub-pixel column.

In some embodiments, centers of three adjacent sub-pixels in a 1^{st} sub-pixel row (which may be referred to as a sub-pixel row I) in three adjacent sub-pixel rows and centers of three adjacent sub-pixels in a 3^{rd} sub-pixel row (which may be referred to as a sub-pixel row III) may form a virtual hexagon. The virtual hexagon includes at least three obtuse angles and at least two acute angles. For ease of description, the 1^{st} sub-pixel row in the three adjacent sub-pixel rows may be referred to as the sub-pixel row I, a 2^{nd} sub-pixel row may be referred to as a sub-pixel row II, and the 3^{rd} sub-pixel row may be referred to as the sub-pixel row III. Three adjacent sub-pixels in the sub-pixel row I are respectively referred to as a sub-pixel A, a sub-pixel B, and a sub-pixel C, and three adjacent sub-pixels in the sub-pixel row III are respectively referred to as a sub-pixel D, a sub-pixel E, and a sub-pixel F, where the sub-pixel A and the sub-pixel D belong to a same column of sub-pixels (which may be referred to as a sub-pixel column I), the sub-pixel B and the sub-pixel E belong to a same column of sub-pixels (which may be referred to as a sub-pixel column II), and the sub-pixel C and the sub-pixel F belong to a same column of sub-pixels (which may be referred to as a sub-pixel column III). The sub-pixel column I, the sub-pixel column II, and the sub-pixel column III are three adjacent columns of sub-pixels of a same type. In other words, if the sub-pixel column I, the sub-pixel column II, and the sub-pixel column III are first-type sub-pixel columns, there is another second-type sub-pixel column between the sub-pixel column I and the sub-pixel column II, and there is another second-type sub-pixel column between the sub-pixel column II and the sub-pixel column III; or if the sub-pixel column I, the sub-pixel column II, and the sub-pixel column III are second-type sub-pixels, there is another first-type sub-pixel column between the sub-pixel column I and the sub-pixel column II, and there is another first-type sub-pixel column between the sub-pixel column II and the sub-pixel column III. It is assumed that there are five adjacent columns of sub-pixels, the sub-pixel column I, the sub-pixel column II, and the sub-pixel column III may be the first column of sub-pixels, the third column of sub-pixels, and the fifth column of sub-pixels in the five columns of adjacent sub-pixels.

For example, in some embodiments, the sub-pixel A may be a sub-pixel 00, the sub-pixel B may be a sub-pixel 02, the sub-pixel C may be a sub-pixel 04, the sub-pixel D may be a sub-pixel 20, the sub-pixel E may be a sub-pixel 22, and the sub-pixel F may be a sub-pixel 24. A center of the sub-pixel 00, a center of the sub-pixel 02, a center of the sub-pixel 04, a center of the sub-pixel 20, a center of the sub-pixel 22, and a center of the sub-pixel 24 form a virtual hexagon.

In some other embodiments, the sub-pixel A may be a sub-pixel 42, the sub-pixel B may be a sub-pixel 44, the sub-pixel C may be a sub-pixel 46, the sub-pixel D may be a sub-pixel 62, the sub-pixel E may be a sub-pixel 64, and the sub-pixel F may be a sub-pixel 66. A center of the sub-pixel 42, a center of the sub-pixel 44, a center of the sub-pixel 46, a center of the sub-pixel 62, a center of the sub-pixel 64, and a center of the sub-pixel 66 form a virtual hexagon.

For another example, in some other embodiments, the sub-pixel A may be a sub-pixel 11, the sub-pixel B may be a sub-pixel 13, the sub-pixel C may be a sub-pixel 15, the sub-pixel D may be a sub-pixel 31, the sub-pixel E may be a sub-pixel 33, and the sub-pixel F may be a sub-pixel 35. A center of the sub-pixel 11, a center of the sub-pixel 13, a center of the sub-pixel 15, a center of the sub-pixel 31, a center of the sub-pixel 33, and a center of the sub-pixel 35 form a virtual hexagon.

For another example, in some other embodiments, the sub-pixel A may be a sub-pixel 33, the sub-pixel B may be a sub-pixel 35, the sub-pixel C may be a sub-pixel 37, the sub-pixel D may be a sub-pixel 53, the sub-pixel E may be a sub-pixel 55, and the sub-pixel F may be a sub-pixel 57. A center of the sub-pixel 33, a center of the sub-pixel 35, a center of the sub-pixel 37, a center of the sub-pixel 53, a center of the sub-pixel 55, and a center of the sub-pixel 57 form a virtual hexagon.

For ease of description, a side that is in the virtual hexagon and that includes a center of the sub-pixel A and a center of the sub-pixel B may be referred to as a side AB, a side that is in the virtual hexagon and that includes the center of the sub-pixel B and a center of the sub-pixel C may be referred to as a side BC, and a side that is in the virtual hexagon and that includes the center of the sub-pixel A and a center of the sub-pixel D may be referred to as a side AD, a side that includes the center of the sub-pixel D and a center of the sub-pixel E may be referred to as a side DE, a side that includes the center of the sub-pixel E and a center of the sub-pixel F is referred to as a side EF, and a side that includes the center of the sub-pixel F and the center of the sub-pixel C is referred to as a side FC. An angle consisting of the side AB and the side BC is referred to as an angle ABC, an angle consisting of the side BC and the side FC is referred to as an angle BCF, an angle consisting of the side AD and the side AB is referred to as an angle DAB, an angle consisting of the side AD and the side DE is referred to as an angle ADE, an angle consisting of the side DE and the side EF is referred to as an angle DEF, and an angle consisting of the side EF and the side FC is referred to as an angle EFC.

In conclusion, the six sides of the virtual hexagon are respectively the side AB, the side BC, the side AD, the side DE, the side EF, and the side FC. The six internal angles of the virtual hexagon are respectively the angle ABC, the angle BCF, the angle DAB, the angle ADE, the angle DEF, and the angle EFC.

The virtual hexagon includes at least three obtuse angles and at least two acute angles. For example, if the virtual hexagon consists of the center of the sub-pixel 00, the center of the sub-pixel 02, the center of the sub-pixel 04, the center of the sub-pixel 20, the center of the sub-pixel 22, and the center of the sub-pixel 24, an angle DAE, the angle ABC, and the angle BCF are three obtuse angles, the angle ADE and the angle EFC are two acute angles, and the angle DEF is a reflex angle. For another example, if the virtual hexagon consists of the center of the sub-pixel 42, the center of the sub-pixel 44, the center of the sub-pixel 46, the center of the sub-pixel 62, the center of the sub-pixel 64, and the center of the sub-pixel 66, the angle ADE, the angle DEF, and the angle EFC are three obtuse angles, the angle DAB and the angle BCF are two acute angles, and the angle ABC is a reflex angle.

In some embodiments, an angle of each of the two acute angles of the virtual hexagon is greater than or equal to 80 degrees and less than or equal to 88 degrees.

In some embodiments, regardless of whether the virtual hexagon consists of centers of the sub-pixels x or consists of centers of the sub-pixels y and centers of the sub-pixels z, the virtual hexagon has a group of parallel sides. For example, if the virtual hexagon consists of the center of the sub-pixel 00, the center of the sub-pixel 02, the center of the sub-pixel 04, the center of the sub-pixel 20, the center of the sub-pixel 22, and the center of the sub-pixel 24, the side AD is parallel to the side CF.

In some embodiments, if the virtual hexagon consists of centers of sub-pixels x, the virtual hexagon has three groups of parallel sides in total. For example, if the virtual hexagon consists of the center of the sub-pixel 00, the center of the sub-pixel 02, the center of the sub-pixel 04, the center of the sub-pixel 20, the center of the sub-pixel 22, and the center of the sub-pixel 24, the side AB is parallel to the side DE, the side BC is parallel to the side EF, and the side AD is parallel to the side FC.

In some embodiments, if the virtual hexagon consists of centers of sub-pixels x, the virtual hexagon may include two groups of equal sides. For example, if the virtual hexagon consists of the center of the sub-pixel 00, the center of the sub-pixel 02, the center of the sub-pixel 04, the center of the sub-pixel 20, the center of the sub-pixel 22, and the center of the sub-pixel 24, the side AB is equal to the side BC, and the side DE is equal to the side EF. For another example, if the virtual hexagon consists of the center of the sub-pixel 42, the center of the sub-pixel 44, the center of the sub-pixel 46, the center of the sub-pixel 62, the center of the sub-pixel 64, and the center of the sub-pixel 66, the side AB is equal to the side BC, and the side DE is equal to the side EF.

The virtual hexagon may be further divided into two virtual quadrilaterals. One virtual quadrilateral in the two virtual quadrilaterals includes centers of four left sub-pixels (that is, the sub-pixel A, the sub-pixel B, the sub-pixel D, and the sub-pixel E), and the other virtual quadrilateral includes centers of four right sub-pixels (that is, the sub-pixel B, the sub-pixel C, the sub-pixel E, and the sub-pixel F). If the virtual hexagon consists of centers of sub-pixels x, the two virtual quadrilaterals are two parallel quadrilaterals. If the virtual hexagon consists of centers of sub-pixels y and centers of sub-pixels z, the two virtual quadrilaterals are two non-parallel quadrilaterals.

For ease of description, the left virtual quadrilateral may be referred to as a quadrilateral ABDE, and the right virtual quadrilateral may be referred to as a quadrilateral BCEF. A sub-pixel is included in each of the quadrilateral ABDE and the quadrilateral BCEF. For example, if the virtual hexagon consists of the center of the sub-pixel 00, the center of the sub-pixel 02, the center of the sub-pixel 04, the center of the sub-pixel 20, the center of the sub-pixel 22, and the center of the sub-pixel 24, the sub-pixel y is in the quadrilateral ABDE, and the sub-pixel z is in the quadrilateral BCEF. For another example, if the virtual hexagon consists of the center of the sub-pixel 42, the center of the sub-pixel 44, the center of the sub-pixel 46, the center of the sub-pixel 62, the center of the sub-pixel 64, and the center of the sub-pixel 66, the sub-pixel z is in the quadrilateral ABDE, and the sub-pixel y is in the quadrilateral BCEF.

In some embodiments, if the virtual quadrilateral is the sub-pixel y, a distance between a center of the sub-pixel y and a center of the virtual quadrilateral is less than a threshold Th₁. A value of Th₁ may be greater than or equal to 3 micrometers and less than or equal to 8 micrometers. For example, the value of Th₁ may be 5 micrometers.

In some embodiments, if a third pixel is in the virtual quadrilateral, a distance between a center of the third pixel and the center of the virtual quadrilateral is greater than a threshold Th₂. A value of Th₂ may be greater than or equal to 0.1 micrometer and less than or equal to 0.5 micrometer. For example, the value of Th₂ may be 0.3 micrometer.

For ease of description, if the distance between the center of the sub-pixel and the center of the virtual quadrilateral is less than the threshold Th₁, it may be considered that the center of the sub-pixel coincides with the center of the virtual quadrilateral; or if the center of the sub-pixel and the center of the virtual quadrilateral are greater than the threshold Th₂, it may be considered that there is an offset between the center of the sub-pixel and the center of the virtual quadrilateral.

In some embodiments, if the third pixel is in the virtual quadrilateral, a distance between the center of the third pixel and a long diagonal of the virtual quadrilateral is less than a threshold Th₃. A value of Th₃ may be greater than or equal to 3 micrometers and less than or equal to 8 micrometers. For example, the value of Th₃ may be 5 micrometers.

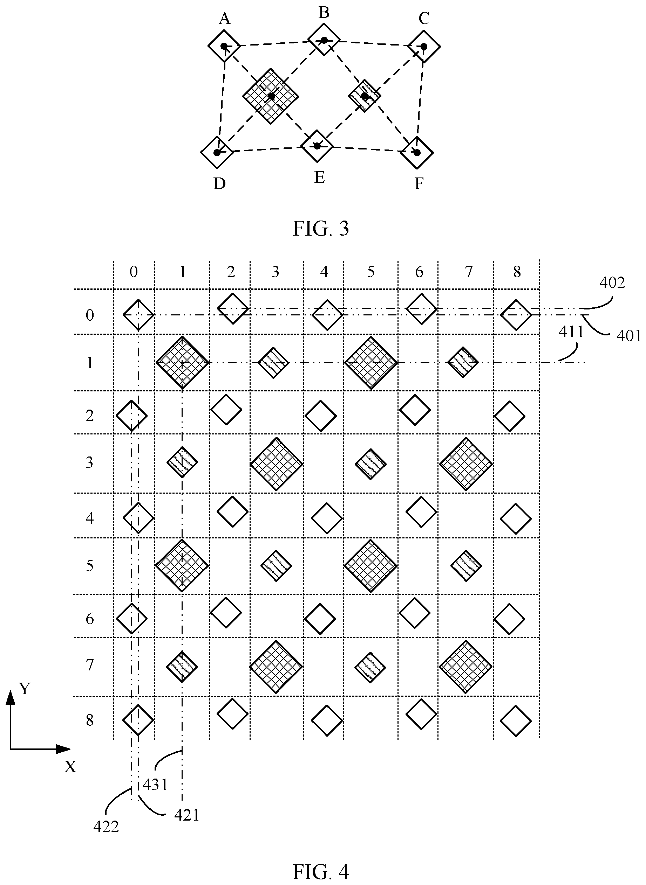

FIG. 3 shows a relationship between two quadrilaterals and pixels in the two quadrilaterals.

As shown in FIG. 3, one sub-pixel y is included in the quadrilateral ABDE, and a center of the sub-pixel y coincides with a center of the quadrilateral ABDE. One sub-pixel z is included in the quadrilateral BCEF, and a center of the sub-pixel z deviates from a center of the quadrilateral BCEF.

In the embodiment shown in FIG. 3, the center of the sub-pixel y coincides with a center of a virtual quadrilateral including the sub-pixel y, and the center of the sub-pixel z deviates from a center of a virtual quadrilateral including the center of the sub-pixel z. In some other embodiments, the center of the sub-pixel z may coincide with a center of a virtual quadrilateral including the sub-pixel z, and the center of the sub-pixel y deviates from a center of the virtual quadrilateral including the center of the sub-pixel y. In some other embodiments, the center of the sub-pixel y coincides with a center of a virtual quadrilateral including the sub-pixel y, and the center of the sub-pixel z may coincide with a center of a virtual quadrilateral including the sub-pixel z. In some other embodiments, the center of the sub-pixel y deviates from a center of a virtual quadrilateral including the center of the sub-pixel y, and a center of the sub-pixel z deviates from a center of a virtual quadrilateral including the center of the sub-pixel z.

Centers of two left pixels (that is, a pixel A and a pixel D) and centers of two right pixels (that is, a pixel C and a pixel F) that form the virtual hexagon may form a virtual quadrilateral. The virtual quadrilateral can be a parallel quadrilateral. More specifically, if centers of sub-pixels x form the virtual hexagon, the quadrilateral may be a parallel quadrilateral. If centers of sub-pixels y and sub-pixels z forms the virtual hexagon, and the sub-pixel A, the sub-pixel C, the sub-pixel D, and the sub-pixel F each are the sub-pixel y, the virtual quadrilateral is a parallel quadrilateral. If centers of sub-pixels y and sub-pixels z forms the virtual hexagon, and the sub-pixel A, the sub-pixel C, the sub-pixel D, and the sub-pixel F each are the sub-pixel z, the virtual quadrilateral is a parallel quadrilateral.

It can be learned that there may be two virtual hexagons in the pixel arrangement structure shown in FIG. 2. The first type of virtual hexagon consists of centers of sub-pixels x. The second type of virtual hexagon consists of centers of sub-pixels y and centers of sub-pixels z.

It is assumed that a sub-pixel row IV is one row of sub-pixels that is adjacent to a sub-pixel row III. In other words, there are four adjacent rows of sub-pixels, the first row of sub-pixels is a sub-pixel I, a second row of sub-pixels is a sub-pixel row II, a third row of sub-pixels is the sub-pixel row III, and the fourth row of sub-pixels is the sub-pixel row IV. It is assumed that there are six adjacent columns of sub-pixels, a sub-pixel column I, a sub-pixel column II, and a sub-pixel column III may be the first column of sub-pixels, the third column of sub-pixels, and the fifth column of sub-pixels in the six columns of adjacent sub-pixels, and a sub-pixel column IV, a sub-pixel column V, and a sub-pixel column VI are the second column of sub-pixels, the fourth column of sub-pixels, and the sixth column of sub-pixels in the six columns of adjacent sub-pixels.

FIG. 2 is used as an example, in some embodiments, the sub-pixel row I to the sub-pixel row IV may be a sub-pixel row 0, a sub-pixel row 1, a sub-pixel row 2, and a sub-pixel row 3 respectively. In some other embodiments, the sub-pixel row I to the sub-pixel row IV may be a sub-pixel row 1, a sub-pixel row 2, a sub-pixel row 3, and a sub-pixel row 4 respectively. In some embodiments, the sub-pixel column I to the sub-pixel column VI are respectively a sub-pixel column 0 to a sub-pixel column 5 in FIG. 2. In some other embodiments, the sub-pixel column I to the sub-pixel column VI are respectively a sub-pixel column 1 to a sub-pixel column 6 in FIG. 2.

Still, three adjacent sub-pixels in the sub-pixel row I are respectively referred to as a sub-pixel A, a sub-pixel B, and a sub-pixel C, and three adjacent sub-pixels in the sub-pixel row III are respectively referred to as a sub-pixel D, a sub-pixel E, and a sub-pixel F. The sub-pixel A and the sub-pixel D belong to the sub-pixel column I, the sub-pixel B and the sub-pixel E belong to the sub-pixel column II, and the sub-pixel C and the sub-pixel F belong to the sub-pixel column III. In addition, three adjacent sub-pixels in a sub-pixel row II are respectively referred to as a sub-pixel P, a sub-pixel Q, and a sub-pixel R, and three adjacent sub-pixels in a sub-pixel row IV are respectively referred to as a sub-pixel S, a sub-pixel T, and a sub-pixel U. The sub-pixel P and the sub-pixel S belong to the sub-pixel column IV, the sub-pixel column Q and the sub-pixel column T belong to the sub-pixel column V, and the sub-pixel column R and the sub-pixel column U belong to the sub-pixel column VI.

Centers of the sub-pixel A, the sub-pixel B, the sub-pixel C, the sub-pixel D, the sub-pixel E, and the sub-pixel F may form a hexagon. For ease of description, a hexagon consisting of the centers of the sub-pixel A, the sub-pixel B, the sub-pixel C, the sub-pixel D, the sub-pixel E, and the sub-pixel F may be referred to as a hexagon A-F. Centers of the sub-pixel P, the sub-pixel Q, the sub-pixel R, the sub-pixel S, the sub-pixel T, and the sub-pixel U may form a hexagon. For ease of description, a hexagon consisting of the centers of the sub-pixel P, the sub-pixel Q, the sub-pixel R, the sub-pixel S, the sub-pixel T, and the sub-pixel U may be referred to as a hexagon P-U. If the sub-pixel A, the sub-pixel B, the sub-pixel C, the sub-pixel D, the sub-pixel E, and the sub-pixel F each are the sub-pixel x, the hexagon A-F is the first type of hexagon, and the hexagon P-U is the second type of hexagon. If the sub-pixel A, the sub-pixel B, the sub-pixel C, the sub-pixel D, the sub-pixel E, and the sub-pixel F each are sub-pixel y or sub-pixel z, the hexagon A-F is the second type of hexagon, and the hexagon P-U is the first type of hexagon.

In some embodiments, the first-type sub-pixel row may include P₁ groups of sub-pixels, each group of sub-pixels in the P₁ groups of sub-pixels includes multiple first sub-pixels, the P₁ groups of sub-pixels one-to-one correspond to P₁ virtual straight lines, centers of the multiple first sub-pixels included in each group of sub-pixels in the P₁ groups of sub-pixels are located on a corresponding virtual straight line, any two virtual straight lines in the P₁ virtual straight lines are parallel, and P₁ is a positive integer greater than or equal to 2.

In some embodiments, any P₁ consecutive sub-pixels in the first-type sub-pixel row respectively belong to the P₁ groups of sub-pixels. Centers of the any P₁ consecutive sub-pixels are respectively located on the P₁ virtual straight lines.

For example, in some embodiments, the first-type sub-pixel row includes two groups of sub-pixels. Any two adjacent first sub-pixels in the first-type sub-pixel row respectively belong to two groups of sub-pixels. Centers of any two adjacent sub-pixels in the first-type sub-pixel row are respectively located on two parallel virtual straight lines. The sub-pixel row 0 is used as an example. Centers of a sub-pixel 00, a sub-pixel 04, and a sub-pixel 08 are located on a virtual straight line 201, and centers of a sub-pixel 02 and a sub-pixel 06 are located on a virtual straight line 202. The virtual straight line 201 is parallel to the virtual straight line 202, a distance between the virtual straight line 201 and the virtual straight line 202 is greater than 0, and the virtual straight line 201 is parallel to an X-axis.

In some embodiments, the second-type sub-pixel row may include P₂ groups of sub-pixels, each group of sub-pixels in the P₂ groups of sub-pixels includes multiple sub-pixels, the P₂ groups of sub-pixels one-to-one correspond to P₂ virtual straight lines, centers of the multiple sub-pixels included in each group of sub-pixels in the P₂ groups of sub-pixels are located on a corresponding virtual straight line, any two virtual straight lines in the P₂ virtual straight lines are parallel, and P₂ is a positive integer greater than or equal to 2.

In some embodiments, any P₂ consecutive sub-pixels in the second-type sub-pixel row respectively belong to the P₂ groups of sub-pixels. Centers of the any P₂ consecutive sub-pixels are respectively located on the P₂ virtual straight lines.

For example, in some embodiments, the second-type sub-pixel row includes two groups of sub-pixels. Any two adjacent sub-pixels in the second-type sub-pixel row respectively belong to two groups of sub-pixels. Centers of any two adjacent sub-pixels in the second-type sub-pixel row are respectively located on different virtual straight lines. The sub-pixel row 1 is used as an example. Centers of the sub-pixel 11 and the sub-pixel 15 are located on a virtual straight line 211. Centers of the sub-pixel 13 and the sub-pixel 17 are located on a virtual straight line 212. The virtual straight line 211 is parallel to the virtual straight line 212, a distance between the virtual straight line 211 and the virtual straight line 212 is greater than 0, and the virtual straight line 211 is parallel to an X-axis.

In some embodiments, the first-type sub-pixel column may include Q₁ groups of sub-pixels, each group of sub-pixels in the Q₁ groups of sub-pixels includes multiple first sub-pixels, the Q₁ groups of sub-pixels one-to-one correspond to Q₁ virtual straight lines, centers of the multiple first sub-pixels included in each group of sub-pixels in the Q₁ groups of sub-pixels are located on a corresponding virtual straight line, any two virtual straight lines in the Q₁ virtual straight lines are parallel, and Q₁ is a positive integer greater than or equal to 2.

In some embodiments, any Q₁ consecutive sub-pixels in the first-type sub-pixel column respectively belong to the Q₁ groups of sub-pixels. Centers of the any Q₁ consecutive sub-pixels are respectively located on the Q₁ virtual straight lines.

For example, in some embodiments, the first-type sub-pixel column includes two groups of sub-pixels. Any two adjacent first sub-pixels in the first-type sub-pixel column respectively belong to two groups of sub-pixels. Centers of any two adjacent sub-pixels in the first-type sub-pixel column are respectively located on different virtual straight lines. The sub-pixel column 0 is used as an example. Centers of a sub-pixel 00, a sub-pixel 40, and a sub-pixel 80 are located on a virtual straight line 221, and centers of a sub-pixel 20 and a sub-pixel 60 are located on a virtual straight line 222. The virtual straight line 221 is parallel to the virtual straight line 222, a distance between the virtual straight line 221 and the virtual straight line 222 is greater than 0, and the virtual straight line 221 is parallel to a Y-axis.

In some embodiments, the second-type sub-pixel column may include Q₂ groups of sub-pixels, each group of sub-pixels in the Q₂ groups of sub-pixels includes multiple sub-pixels, the Q₂ groups of sub-pixels one-to-one correspond to Q₂ virtual straight lines, centers of the multiple sub-pixels included in each group of sub-pixels in the Q₂ groups of sub-pixels are located on a corresponding virtual straight line, any two virtual straight lines in the Q₂ virtual straight lines are parallel, and Q₂ is a positive integer greater than or equal to 2.

In some embodiments, any Q₂ consecutive sub-pixels in the second-type sub-pixel column respectively belong to the Q₂ groups of sub-pixels. Centers of the any Q₂ consecutive sub-pixels are respectively located on the Q₂ virtual straight lines.

For example, in some embodiments, the second-type sub-pixel column includes two groups of sub-pixels. Any two adjacent sub-pixels in the second-type sub-pixel column respectively belong to two groups of sub-pixels. Centers of any two adjacent sub-pixels in second-type sub-pixel column are respectively located on different virtual straight lines. The sub-pixel column 1 is used as an example. Centers of a sub-pixel 11 and a sub-pixel 51 are located on a virtual straight line 231. Centers of a sub-pixel 31 and a sub-pixel 71 are located on a virtual straight line 232. The virtual straight line 231 is parallel to the virtual straight line 232, a distance between the virtual straight line 231 and the virtual straight line 232 is greater than 0, and the virtual straight line 231 is parallel to a Y-axis.

All adjacent sub-pixels in the foregoing embodiment belong to different groups of sub-pixels. In some other embodiments, some two adjacent sub-pixels may be a same group of sub-pixels. For example, the first-type sub-pixel row includes two groups of sub-pixels. The 1^{st} sub-pixel and the 2^{nd} sub-pixel in the four adjacent sub-pixels belong to a same group of sub-pixels, and the 3^{rd} sub-pixel and the 4^{th} sub-pixel belong to another group of sub-pixels.

A distance between virtual straight lines in which centers of sub-pixels belonging to a same row or a same column are located is less than a distance threshold; and a distance between virtual straight lines in which centers of sub-pixels belonging to different rows or different columns are located is greater than the distance threshold. For example, a distance between the virtual straight line 201 and the virtual straight line 202 is less than the distance threshold, and a distance between the virtual straight line 201 and the virtual straight line 211 is greater than the distance threshold. In other words, if a distance between two parallel virtual straight lines (the two virtual straight lines are parallel to the X-axis or the Y-axis) in which centers of two sub-pixels are located is less than the distance threshold, it may be considered that the two sub-pixels are two sub-pixels belonging to a same row or a same column; or if a distance between two parallel virtual straight lines (the two virtual straight lines are parallel to the X-axis or the Y-axis) in which the two sub-pixels are located is greater than the distance threshold, in this case, it may be considered that the two sub-pixels are two sub-pixels that belong to different rows or different columns.

In some embodiments, the sub-pixel may be a regular shape. For example, the sub-pixel may be a regular polygon, a circle, an ellipse, or a rounded polygon.

In some other embodiments, the sub-pixel may be an irregular shape. For example, the sub-pixel is a shape having a concave part or a convex part.

In some embodiments, the sub-pixel x, the sub-pixel y, and the sub-pixel z may have the same shape. For example, the sub-pixel x, the sub-pixel y, and the sub-pixel z each are a square.

In some other embodiments, different sub-pixels may have different shapes. For example, the sub-pixel x is a square, the sub-pixel y is a circle, and the sub-pixel z is an ellipse.

If a sub-pixel is a regular shape, a center of the sub-pixel is a center of the regular shape. If a sub-pixel is an irregular shape, a center of the sub-pixel may be a center of a circumscribed polygon or circumscribed circle of the sub-pixel.

In some embodiments, if the sub-pixel x emits green light, the sub-pixel y emits blue light, and the sub-pixel z emits red light, an area of the sub-pixel y is greater than that of the sub-pixel x, and an area of the sub-pixel y is greater than that of the sub-pixel z.

Compared with the regular arrangement of sub-pixels, the sub-pixels x in the foregoing technical solution are arranged in an offset manner, that is, centers of sub-pixels x in a same row are not in a same straight line. In this arrangement manner, a distance between a central point of the sub-pixel x and a central point of the sub-pixel y may be shortened. In this way, at a same deviation angle, a sub-pixel offset can be reduced according to the foregoing technical solutions. This reduces impact of a photomask alignment deviation on an actual pixel offset, improves edge chromatic aberration and sawtooth sense of display effect, and reduces diffraction effect.

In addition, the foregoing technical solution may further have better effect of reducing a moire. Specifically, because sub-pixels of the same attribute are not located on a same straight line, four different unit arrangements are formed again. After the fast Fourier transform (fast Fourier transform, FFT) is spread, the four different unit arrangements correspond to four different frequencies, and strength of the moire is scattered on two different frequencies. In this way, the moire strength can be reduced.

A current applied to a sub-pixel is inversely proportional to an area of the sub-pixel. In other words, the larger the area, the smaller the current required to maintain the same luminance, the smaller the corresponding power consumption, and the better the service life and reliability. In this way, in the foregoing technical solution, an area of the sub-pixel y is increased, so that a current of maintaining same luminance for the sub-pixel y can be reduced. This reduces power consumption of the sub-pixel y, and improves service life and reliability of the sub-pixel y. In addition, a larger sub-pixel area indicates a larger aperture ratio. Therefore, an aperture ratio of the sub-pixel y can be further improved according to the foregoing technical solution.

FIG. 4 is a diagram of another pixel arrangement structure according to an embodiment of this application. It may be understood that the pixel arrangement structure shown in FIG. 4 is an arrangement structure of some of pixels included in a display panel.

The arrangement manner of the sub-pixels x in the pixel arrangement structure shown in FIG. 4 is the same as the arrangement manner of the sub-pixels x in the pixel arrangement structure shown in FIG. 2. For example, a center of the sub-pixel 00, a center of the sub-pixel 02, a center of the sub-pixel 04, a center of the sub-pixel 20, a center of the sub-pixel 22, and a center of the sub-pixel 24 may form a virtual hexagon, and the virtual hexagon includes at least three obtuse angles and at least two acute angles. For another example, centers of the sub-pixel 00, the sub-pixel 04, and the sub-pixel 08 are located on a virtual straight line 401; centers of the sub-pixel 02 and the sub-pixel 06 are located on a virtual straight line 402; centers of the sub-pixel 00, the sub-pixel 40, and the sub-pixel 80 are located on a virtual straight line 421; and centers of the sub-pixel 20 and the sub-pixel 60 are located on a virtual straight line 422. For a specific arrangement structure of the sub-pixels x, refer to the embodiment shown in FIG. 2. For brevity, details are not described herein.

Centers of any two adjacent sub-pixels in the second-type sub-pixel row (that is, a sub-pixel row in which the sub-pixel y and the sub-pixel z are alternately set) in the pixel arrangement structure shown in FIG. 4 are located on a same virtual straight line. For example, centers of the sub-pixel 11, the sub-pixel 13, the sub-pixel 15, and the sub-pixel 17 are all located on a virtual straight line 411. For another example, centers of the sub-pixel 11, the sub-pixel 31, the sub-pixel 51, and the sub-pixel 71 are all located on a virtual straight line 431. In this case, a shape consisting of sub-pixels y and sub-pixels z may be a quadrilateral.

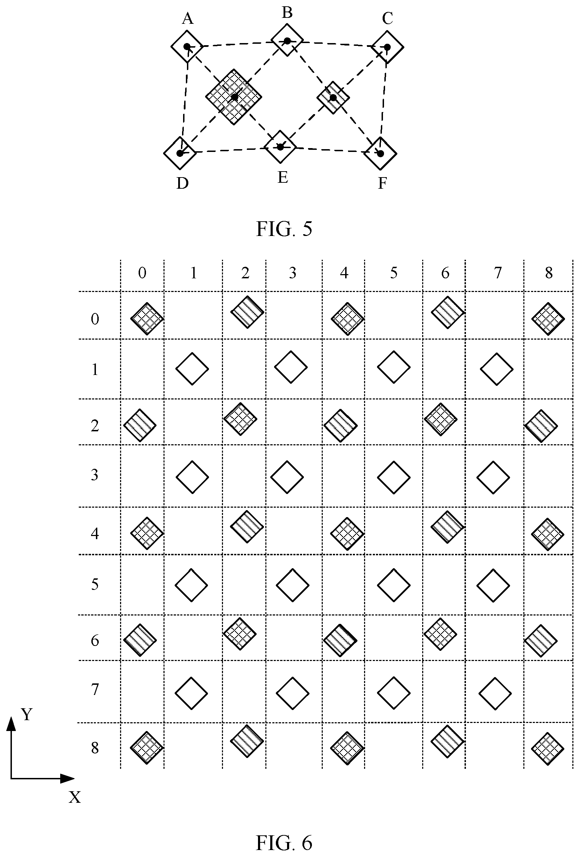

FIG. 5 shows a relationship between two quadrilaterals consisting of sub-pixels x in the pixel arrangement structure shown in FIG. 4 and sub-pixels in the quadrilateral.

As shown in FIG. 5, one sub-pixel y is included in the quadrilateral ABDE, and a center of the sub-pixel y coincides with a center of the quadrilateral ABDE. One sub-pixel z is included in the quadrilateral BCEF, and a center of the sub-pixel z coincides with a center of the quadrilateral BCEF.

FIG. 6 is a diagram of another pixel arrangement structure according to an embodiment of this application. It may be understood that the pixel arrangement structure shown in FIG. 6 is an arrangement structure of some of pixels included in a display panel.

An arrangement manner of sub-pixels y and sub-pixels z in the pixel arrangement structure shown in FIG. 6 is the same as the arrangement manner of sub-pixels x in the pixel arrangement structure shown in FIG. 4, that is, centers of the adjacent sub-pixel y and the sub-pixel z are located on different virtual straight lines. An arrangement manner of sub-pixels x in the pixel arrangement structure shown in FIG. 6 is the same as the arrangement manner of sub-pixels y and sub-pixels z in the pixel arrangement manner shown in FIG. 4, that is, centers of two adjacent sub-pixels x are located on a same virtual straight line.

In addition, sizes of the sub-pixel x, the sub-pixel y, and the sub-pixel z shown in FIG. 6 are the same.

A person skilled in the art may understand that FIG. 2, FIG. 4, and FIG. 6 are merely diagrams of three different pixel arrangement structures according to the technical solutions provided in embodiments of this application. According to the technical solutions provided in embodiments of this application, a person skilled in the art may further obtain another pixel arrangement structure.

For example, a pixel arrangement structure is the same as the pixel arrangement structure shown in FIG. 2, but sizes of the sub-pixel x, the sub-pixel y, and the sub-pixel z are the same.

For another example, a pixel arrangement structure is the same as the pixel arrangement structure shown in FIG. 2, but sub-pixels x in the sub-pixel row 0, the sub-pixel row 2, the sub-pixel row 4, the pixel row 6, and the sub-pixel row 8 shown in FIG. 2 are replaced with sub-pixels y and sub-pixels z that are alternately arranged, and sub-pixels y and sub-pixels z in the sub-pixel row 1, the sub-pixel row 3, the sub-pixel row 5, and the sub-pixel row 7 shown in FIG. 2 are replaced with sub-pixels x.

For another example, a pixel arrangement structure is the same as the pixel arrangement structure shown in FIG. 2, but sub-pixels x in the sub-pixel row 0, the sub-pixel row 2, the sub-pixel row 4, the pixel row 6, and the sub-pixel row 8 shown in FIG. 2 are replaced with sub-pixels z, and sub-pixels z in the sub-pixel row 1, the sub-pixel row 3, the sub-pixel row 5, and the sub-pixel row 7 shown in FIG. 2 are replaced with sub-pixels x.

For another example, in the arrangement results shown in FIG. 2, FIG. 4, and FIG. 6, it is assumed that values of P₁, P₂, Q₁, and Q₂ are 2. In some other embodiments, values of P₁, P₂, Q₁, and Q₂ may also be other positive integers greater than or equal to 2. For example, P₁=P₂=Q₁=Q₂=3. In some other embodiments, values of P₁, P₂, Q₁, and Q₂ may not be completely the same. For example, in some embodiments, P₁=P₂=2, and Q₁=Q₂=3.

When P₁=P₂=Q₁=Q₂=2, the pixel arrangement structure is made more easily.

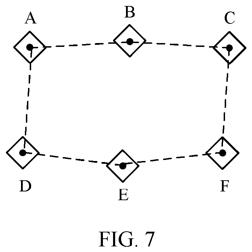

In addition, in the foregoing embodiment, the hexagon consisting of the sub-pixel A, the sub-pixel B, the sub-pixel C, the sub-pixel D, the sub-pixel E, and the sub-pixel F includes three obtuse angles, two acute angles, and one reflex angle. In some other embodiments, the hexagon consisting of the sub-pixel A, the sub-pixel B, the sub-pixel C, the sub-pixel D, the sub-pixel E, and the sub-pixel F may further include four obtuse angles and two acute angles, or three obtuse angles and three acute angles. For example, FIG. 7 is a diagram of another hexagon consisting of a sub-pixel A, a sub-pixel B, a sub-pixel C, a sub-pixel D, a sub-pixel E, and a sub-pixel F according to an embodiment of this application.

In the hexagon shown in FIG. 7, an angle DAE, an angle ABC, an angle BCF, and an angle DEF are four obtuse angles, and an angle ADE and an angle EFC are two acute angles.

An embodiment of this application provides a pixel arrangement structure. The pixel arrangement structure includes sub-pixels arranged into a structure of N rows and M columns, and both N and M are positive integers greater than or equal to 3. A first sub-pixel row, a second sub-pixel row, and a third sub-pixel row are three adjacent rows of sub-pixels in N rows of sub-pixels, and the second sub-pixel row is located between the first sub-pixel row and the third sub-pixel row. A first sub-pixel, a second sub-pixel, and a third sub-pixel are three adjacent sub-pixels in the first sub-pixel row. A fourth sub-pixel, a fifth sub-pixel, and a sixth sub-pixel are three adjacent sub-pixels in the third sub-pixel row. The first sub-pixel and the fourth sub-pixel belong to a first sub-pixel column, the second sub-pixel and the fifth sub-pixel belong to a second sub-pixel column, the third sub-pixel and the sixth sub-pixel belong to a third sub-pixel column, the first sub-pixel column, the second sub-pixel column, and the third sub-pixel column are three columns of sub-pixels in M columns of sub-pixels, and the second sub-pixel column is located between the first sub-pixel column and the third sub-pixel column. A center of the first sub-pixel, a center of the second sub-pixel, a center of the third sub-pixel, a center of the fourth sub-pixel, a center of the fifth sub-pixel, and a center of the sixth sub-pixel form a virtual hexagon, and the virtual hexagon includes at least three obtuse angles and at least two acute angles.

For example, the first sub-pixel row may be the sub-pixel row I referred to in the foregoing embodiment, the second sub-pixel row may be the sub-pixel row II referred to in the foregoing embodiment, and the third sub-pixel column may be the sub-pixel row III referred to in the foregoing embodiment. The first sub-pixel column may be the sub-pixel column I referred to in the foregoing embodiment, the second sub-pixel column may be the sub-pixel column II referred to in the foregoing embodiment, and the third sub-pixel column may be the sub-pixel column III referred to in the foregoing embodiment. The first sub-pixel is the sub-pixel A referred to in the foregoing embodiment, the second sub-pixel is the sub-pixel B referred to in the foregoing embodiment, the third sub-pixel is the sub-pixel C referred to in the foregoing embodiment, the fourth sub-pixel is the sub-pixel D referred to in the foregoing embodiment, the fifth sub-pixel is the sub-pixel E referred to in the foregoing embodiment, and the sixth sub-pixel is the sub-pixel F referred to in the foregoing embodiment.

For another example, the first sub-pixel row to the third sub-pixel row may be respectively the sub-pixel row 0, the sub-pixel row 1, and the sub-pixel row 2 shown in FIG. 2, and the first sub-pixel column to the third sub-pixel column may be respectively the sub-pixel column 0, the sub-pixel column 2, and the sub-pixel column 4 shown in FIG. 2. The first sub-pixel to the sixth sub-pixel may be respectively the sub-pixel 00, the sub-pixel 02, the sub-pixel 04, the sub-pixel 20, the sub-pixel 22, and the sub-pixel 24 shown in FIG. 2.

For another example, the first sub-pixel row to the third sub-pixel row may be respectively the sub-pixel row 4, the sub-pixel row 5, and the sub-pixel row 6 shown in FIG. 2, and the first sub-pixel column to the third sub-pixel column may be respectively the sub-pixel column 2, the sub-pixel column 4, and the sub-pixel column 6 shown in FIG. 2. The first sub-pixel to the sixth sub-pixel may be respectively the sub-pixel 42, the sub-pixel 44, the sub-pixel 46, the sub-pixel 62, the sub-pixel 64, and the sub-pixel 66 shown in FIG. 2.

For another example, the first sub-pixel row to the third sub-pixel row may be respectively the sub-pixel row 1, the sub-pixel row 2, and the sub-pixel row 3 shown in FIG. 2, and the first sub-pixel column to the third sub-pixel column may be respectively the sub-pixel column 1, the sub-pixel column 3, and the sub-pixel column 5 shown in FIG. 2. The first sub-pixel to the sixth sub-pixel may be respectively the sub-pixel 11, the sub-pixel 13, the sub-pixel 15, the sub-pixel 31, the sub-pixel 33, and the sub-pixel 35 shown in FIG. 2.

For another example, the first sub-pixel row to the third sub-pixel row may be respectively the sub-pixel row 3, the sub-pixel row 4, and the sub-pixel row 5 shown in FIG. 2, and the first sub-pixel column to the third sub-pixel column may be respectively the sub-pixel column 3, the sub-pixel column 5, and the sub-pixel column 7 shown in FIG. 2. The first sub-pixel to the sixth sub-pixel may be respectively the sub-pixel 33, the sub-pixel 35, the sub-pixel 37, the sub-pixel 53, the sub-pixel 55, and the sub-pixel 57 shown in FIG. 2.

In some embodiments, the first sub-pixel, the second sub-pixel, the third sub-pixel, the fourth sub-pixel, the fifth sub-pixel, and the sixth sub-pixel are configured to emit light of a first color.

For example, if the first sub-pixel, the second sub-pixel, the third sub-pixel, the fourth sub-pixel, the fifth sub-pixel, and the sixth sub-pixel are sub-pixels x in the embodiment shown in FIG. 2, the first sub-pixel, the second sub-pixel, the third sub-pixel, the fourth sub-pixel, the fifth sub-pixel, and the sixth sub-pixel may be configured to transmit light of a same color.

In some embodiments, a side length of a first side of the virtual hexagon is equal to a side length of a second side of the virtual hexagon, a side length of a third side of the virtual hexagon is equal to a side length of a fourth side of the virtual hexagon, endpoints of the first side are the center of the first sub-pixel and the center of the second sub-pixel, endpoints of the second side are the center of the second sub-pixel and the center of the third sub-pixel, endpoints of the third side are the center of the fourth sub-pixel and the center of the fifth sub-pixel, and endpoints of the fourth side are the center of the fifth sub-pixel and the center of the sixth sub-pixel.

For example, the first side may be the side AB in the foregoing embodiment, the second side may be the side BC in the foregoing embodiment, the third side may be the side DE in the foregoing embodiment, and the fourth side may be the side EF in the foregoing embodiment.

In some embodiments, the second sub-pixel row includes a seventh sub-pixel and an eighth sub-pixel, a distance between a center of the seventh sub-pixel and a center of a first virtual quadrilateral is less than a first threshold, and the first virtual quadrilateral includes the center of the first sub-pixel, the center of the second sub-pixel, the center of the fourth sub-pixel, and the center of the fifth sub-pixel; and a distance between a center of the eighth sub-pixel and a center of a second virtual quadrilateral is greater than a second threshold, and the second virtual quadrilateral includes the center of the second sub-pixel, the center of the third sub-pixel, the center of the fifth sub-pixel, and the center of the sixth sub-pixel.

In some embodiments, a distance between the center of the eighth sub-pixel and a long diagonal of the second virtual quadrilateral is less than a third threshold.

In some embodiments, the seventh sub-pixel is configured to emit light of a second color, and the eighth sub-pixel is configured to emit light of a third color.

For example, the seventh sub-pixel may be a sub-pixel y in the quadrilateral ABDE or the quadrilateral BCEF in the foregoing embodiment, and the eighth sub-pixel may be a sub-pixel z in the quadrilateral ABDE or the quadrilateral BCEF in the foregoing embodiment.

In some embodiments, the first sub-pixel, the third sub-pixel, and the fifth sub-pixel are configured to emit light of a second color; and the second sub-pixel, the fourth sub-pixel, and the sixth sub-pixel are configured to emit light of a third color.

In some embodiments, the at least two acute angles include acute angles greater than or equal to 80 degrees and less than or equal to 88 degrees.

For example, the angle ADE and the angle EFC in the foregoing embodiment are acute angles greater than or equal to 80 degrees and less than or equal to 88 degrees.

In some embodiments, the first color is green.

In some embodiments, the second color is blue, and the third pixel is red.

In some other embodiments, the first color, the second color, and the third color may also be another color configuration. For example, the first color, the second color, and the third color may be blue, green, and red respectively. For another example, the first color, the second color, and the third color may be red, blue, and green respectively. For another example, the first color, the second color, and the third color may be red, green, and blue respectively.

In some embodiments, an area of a pixel configured to emit blue light is greater than an area of a pixel configured to emit red light, and the area of the pixel configured to emit blue light is greater than an area of a pixel configured to emit green light.

In some embodiments, a shape of each sub-pixel in the pixel arrangement structure is a polygon, an ellipse, a circle, or a rounded polygon.

In some embodiments, the N rows of sub-pixels further include a fourth sub-pixel row, and the fourth sub-pixel row is adjacent to the third sub-pixel row. In other words, the first sub-pixel row, the second sub-pixel row, the third sub-pixel row, and the fourth sub-pixel row are four adjacent sub-pixel rows in the N rows of sub-pixels. The first sub-pixel row, the second sub-pixel row, the third sub-pixel row, and the fourth sub-pixel row are respectively the first row of sub-pixels, the second row of sub-pixels, the third row of sub-pixels, and the fourth row of sub-pixels in the four adjacent sub-pixel rows. A ninth sub-pixel, a tenth sub-pixel, and an eleventh sub-pixel are three adjacent sub-pixels in the second sub-pixel row, and a twelfth sub-pixel, a thirteenth sub-pixel, and a fourteenth sub-pixel are three adjacent sub-pixels in the fourth sub-pixel row. The ninth sub-pixel and the twelfth sub-pixel belong to a fourth sub-pixel column, the tenth sub-pixel and the thirteenth sub-pixel belong to a fifth sub-pixel column, and the eleventh sub-pixel and the fourteenth sub-pixel belong to a sixth sub-pixel column. The fourth sub-pixel column, the fifth sub-pixel column, and the sixth sub-pixel column are three columns of sub-pixels in the M sub-pixel columns, and the fifth sub-pixel column is located between the fourth sub-pixel column and the sixth sub-pixel column. A center of the ninth sub-pixel, a center of the tenth sub-pixel, a center of the eleventh sub-pixel, a center of the twelfth sub-pixel, a center of the thirteenth sub-pixel, and a center of the fourteenth sub-pixel form a virtual hexagon, and the virtual hexagon includes at least three obtuse angles and at least two acute angles.

For example, the ninth sub-pixel, the tenth sub-pixel, the eleventh sub-pixel, the twelfth sub-pixel, the thirteenth sub-pixel, and the fourteenth sub-pixel may be respectively the sub-pixel P, the sub-pixel Q, the sub-pixel R, the sub-pixel S, the sub-pixel T, and the sub-pixel U in the foregoing embodiment. The fourth sub-pixel row is the sub-pixel row IV in the foregoing embodiment. The fourth sub-pixel column, the fifth sub-pixel column, and the sixth sub-pixel column are respectively the sub-pixel column IV, the sub-pixel column V, and the sub-pixel column VI in the foregoing embodiment.

In some embodiments, when the first sub-pixel, the second sub-pixel, the third sub-pixel, the fourth sub-pixel, the fifth sub-pixel, and the sixth sub-pixel are configured to emit light of a first color, the ninth sub-pixel, the eleventh sub-pixel, and the thirteenth sub-pixel are configured to emit light of a second color, and the tenth sub-pixel, the twelfth sub-pixel, and the fourteenth sub-pixel are configured to emit light of a third color.

For example, if the first sub-pixel, the second sub-pixel, the third sub-pixel, the fourth sub-pixel, the fifth sub-pixel, and the sixth sub-pixel are pixels x, the ninth sub-pixel, the eleventh sub-pixel, and the thirteenth sub-pixel are pixels y, and the tenth sub-pixel, the twelfth sub-pixel, and the fourteenth sub-pixel are pixels z. In this case, a hexagon consisting of centers of the first sub-pixel, the second sub-pixel, the third sub-pixel, the fourth sub-pixel, the fifth sub-pixel, and the sixth sub-pixel is the first type of hexagon, and a hexagon consisting of centers of the ninth sub-pixel, the tenth sub-pixel, the eleventh sub-pixel, the twelfth sub-pixel, the thirteenth sub-pixel, and the fourteenth sub-pixel is the second type of hexagon.

In some embodiments, when the first sub-pixel, the third sub-pixel, and the fifth sub-pixel are configured to emit light of a second color, and the second sub-pixel, the fourth sub-pixel, and the sixth sub-pixel are configured to emit light of a third color, the ninth sub-pixel, the tenth sub-pixel, the eleventh sub-pixel, the twelfth sub-pixel, the thirteenth sub-pixel, and the fourteenth sub-pixel are configured to emit light of a first color.

For example, the first sub-pixel, the third sub-pixel, and the fifth sub-pixel are pixels y, the fourth sub-pixel and the sixth sub-pixel are pixels z, and the ninth sub-pixel, the tenth sub-pixel, the eleventh sub-pixel, the twelfth sub-pixel, the thirteenth sub-pixel, and the fourteenth sub-pixel are pixels x. In this case, a hexagon consisting of centers of the first sub-pixel, the second sub-pixel, the third sub-pixel, the fourth sub-pixel, the fifth sub-pixel, and the sixth sub-pixel is the second type of hexagon, and a hexagon consisting of centers of the ninth sub-pixel, the tenth sub-pixel, the eleventh sub-pixel, the twelfth sub-pixel, the thirteenth sub-pixel, and the fourteenth sub-pixel is the first type of hexagon.

If the hexagon consisting of centers of the ninth sub-pixel, the tenth sub-pixel, the eleventh sub-pixel, the twelfth sub-pixel, the thirteenth sub-pixel, and the fourteenth sub-pixel is the first type of hexagon (in other words, the ninth sub-pixel, the tenth sub-pixel, the eleventh sub-pixel, the twelfth sub-pixel, the thirteenth sub-pixel, and the fourteenth sub-pixel are configured to emit light of the first color), the hexagon also includes two groups of equal sides. For example, the first group of equal sides includes a fifth side and a sixth side, two endpoints of the fifth side are centers of the ninth sub-pixel and the tenth sub-pixel respectively, and two endpoints of the sixth side are centers of the tenth sub-pixel and the eleventh sub-pixel respectively. The second group of equal sides includes a seventh side and an eighth side, two endpoints of the seventh side are centers of the twelfth sub-pixel and the thirteenth sub-pixel respectively, and two endpoints of the eighth side are centers of the thirteenth sub-pixel and the fourteenth sub-pixel respectively.

If the hexagon consisting of the centers of the ninth sub-pixel, the tenth sub-pixel, the eleventh sub-pixel, the twelfth sub-pixel, the thirteenth sub-pixel, and the fourteenth sub-pixel is the first type of hexagon, the centers of the ninth sub-pixel, the tenth sub-pixel, the twelfth sub-pixel, and the thirteenth sub-pixel may also form a virtual quadrilateral, and the virtual quadrilateral includes one sub-pixel. A relationship between the sub-pixel and the virtual quadrilateral is the same as a relationship between the seventh sub-pixel and the first virtual quadrilateral in the foregoing embodiment. For brevity, details are not described herein. Similarly, centers of the tenth sub-pixel, the eleventh sub-pixel, the thirteenth sub-pixel, and the fourteenth sub-pixel may also form a virtual quadrilateral, and the virtual quadrilateral includes one sub-pixel. A relationship between the sub-pixel and the virtual quadrilateral is the same as a relationship between the eighth sub-pixel and the second virtual quadrilateral in the foregoing embodiment. For brevity, details are not described herein.

Similar to the hexagon consisting of the centers of the first sub-pixel to the sixth sub-pixel, at least two acute angles of the hexagon consisting of the centers of the ninth sub-pixel to the fourteenth sub-pixel include acute angles greater than or equal to 80 degrees and less than or equal to 88 degrees.

An embodiment of this application provides a pixel arrangement structure. The pixel arrangement structure includes sub-pixels arranged into a structure of N rows and M columns, and both N and M are positive integers greater than or equal to 3. N rows of sub-pixels include a first sub-pixel row and a second sub-pixel row, and the first sub-pixel row and the second sub-pixel row are two adjacent rows of sub-pixels in the N rows of sub-pixels. P₁ groups of sub-pixels are arranged in the first sub-pixel row, each group of sub-pixels in the P₁ groups of sub-pixels includes multiple first sub-pixels, the P₁ groups of sub-pixels one-to-one correspond to P₁ virtual straight lines, centers of the multiple first sub-pixels included in each group of sub-pixels in the P₁ groups of sub-pixels are located on a corresponding virtual straight line, any two virtual straight lines in the P₁ virtual straight lines are parallel, and P₁ is a positive integer greater than or equal to 2. A second sub-pixel and a third sub-pixel are alternately arranged in the second sub-pixel row.

For example, the first sub-pixel may be the pixel x in the foregoing embodiment, the second sub-pixel may be the pixel y in the foregoing embodiment, and the third sub-pixel may be the pixel z in the foregoing embodiment. The first sub-pixel row and the second sub-pixel row may be respectively the sub-pixel row 0 and the sub-pixel row 1 in the embodiment shown in FIG. 2. For another example, the first sub-pixel row and the second sub-pixel row may be respectively the sub-pixel row 2 and the sub-pixel row 3 in the embodiment shown in FIG. 2. For another example, the first sub-pixel row and the second sub-pixel row may be respectively the sub-pixel row 0 and the sub-pixel row 1 shown in FIG. 4.

For example, the first sub-pixel row includes two groups of sub-pixels, and each group of sub-pixels in the two groups of sub-pixels includes multiple first sub-pixels. Any two adjacent first sub-pixels in the first sub-pixel row respectively belong to two groups of sub-pixels. In this case, centers of any two adjacent sub-pixels in the first sub-pixel row are respectively located on two different virtual straight lines. The two virtual straight lines may be respectively referred to as a first virtual straight line and a second virtual straight line, the first virtual straight line is parallel to the second virtual straight line, and a distance between the first virtual straight line and the second virtual straight line is greater than 0. In this case, if the first sub-pixel row and the second sub-pixel row are respectively the sub-pixel row 0 and the sub-pixel row 1 in the embodiment shown in FIG. 2, the first virtual straight line and the second virtual straight line may be respectively the virtual straight line 201 and the virtual straight line 202 in the embodiment shown in FIG. 2.

In some embodiments, the second sub-pixel row includes P₂ groups of sub-pixels, each group of sub-pixels in the P₁ groups of sub-pixels includes multiple sub-pixels, the P₂ groups of sub-pixels one-to-one correspond to P₂ virtual straight lines, centers of the multiple sub-pixels included in each group of sub-pixels in the P₂ groups of sub-pixels are located on a corresponding virtual straight line, any two virtual straight lines in the P₂ virtual straight lines are parallel, and P₂ is a positive integer greater than or equal to 2.

For example, the second sub-pixel row includes two groups of sub-pixels. In the two groups of sub-pixels, one group of sub-pixels includes multiple second sub-pixels, and the other group of sub-pixels includes multiple third sub-pixels. Any two adjacent sub-pixels in the second sub-pixel row respectively belong to two groups of sub-pixels. In this case, centers of any two adjacent sub-pixels in the second sub-pixel row are respectively located on two different virtual straight lines. The two virtual straight lines may be respectively referred to as a third virtual straight line and a fourth virtual straight line, the third virtual straight line is parallel to the fourth virtual straight line, and a distance between the third virtual straight line and the fourth virtual straight line is greater than 0. In this case, if the second sub-pixel row is the sub-pixel row 1 in the embodiment shown in FIG. 2, the third virtual straight line and the fourth virtual straight line may be respectively the virtual straight line 211 and the virtual straight line 212 in the embodiment shown in FIG. 2.

In some embodiments, the N rows of sub-pixels further include a third sub-pixel row, the first sub-pixel row, the second sub-pixel row, and the third sub-pixel row are three adjacent rows of sub-pixels in the N rows of sub-pixels, and the second sub-pixel row is located between the first sub-pixel row and the third sub-pixel row. Multiple first sub-pixels are arranged in the third sub-pixel row, P₃ groups of sub-pixels are arranged in the third sub-pixel row, each group of sub-pixels in the P₃ groups of sub-pixels includes multiple first sub-pixels, the P₃ groups of sub-pixels one-to-one correspond to P₃ virtual straight lines, centers of the multiple first sub-pixels included in each group of sub-pixels in the P₃ groups of sub-pixels are located on a corresponding virtual straight line, any two virtual straight lines in the P₃ virtual straight lines are parallel, and P₃ is a positive integer greater than or equal to 2. A center of a first target sub-pixel and a center of a second target sub-pixel are respectively located on two parallel virtual straight lines, where the first target sub-pixel is a sub-pixel in the first sub-pixel row, the second target sub-pixel is a sub-pixel in the third sub-pixel row, the first target sub-pixel and the second target sub-pixel belong to a first sub-pixel column, and the first sub-pixel column is one column of sub-pixels in M columns of sub-pixels.

For example, the third sub-pixel row includes two groups of sub-pixels, and each group of sub-pixels in the two groups of sub-pixels includes multiple first sub-pixels. Any two adjacent first sub-pixels in the third sub-pixel row respectively belong to two groups of sub-pixels. In this case, centers of any two adjacent sub-pixels in the third sub-pixel row are respectively located on two different virtual straight lines. The two virtual straight lines may be respectively referred to as a fifth virtual straight line and a sixth virtual straight line, the fifth virtual straight line is parallel to the sixth virtual straight line, and a distance between the fifth virtual straight line and the sixth virtual straight line is greater than 0. The center of the first target sub-pixel and the center of the second target sub-pixel may be respectively located on a seventh virtual straight line and an eighth virtual straight line. In this case, the first sub-pixel row, the second sub-pixel row, and the third sub-pixel row may be respectively the sub-pixel row 0, the sub-pixel row 1, and the sub-pixel row 2 shown in FIG. 2. The first sub-pixel column may be the sub-pixel column 0 in the embodiment shown in FIG. 2. The seventh virtual straight line and the eighth virtual straight line may be the virtual straight line 221 and the virtual straight line 222 in the embodiment shown in FIG. 2.

In some embodiments, a connection line of a center of a third target sub-pixel, a center of a fourth target sub-pixel, the center of the first target sub-pixel, and the center of the second target sub-pixel forms a first quadrilateral, the first quadrilateral is a parallel quadrilateral, the third target pixel is a sub-pixel that is adjacent to the first target sub-pixel and that is in the first sub-pixel row, the fourth target sub-pixel is a sub-pixel that is adjacent to the second target sub-pixel and that is in the third sub-pixel row, the third target pixel and the fourth target pixel belong to a second sub-pixel column, and the second sub-pixel column and the first sub-pixel column are two columns of sub-pixels in the M columns of sub-pixels.

For example, the first target sub-pixel, the third target sub-pixel, the second target sub-pixel, and the fourth target sub-pixel may be respectively the sub-pixel A, the sub-pixel B, the sub-pixel D, and the sub-pixel E in the foregoing embodiment. In this case, the first quadrilateral may be the quadrilateral ABDE in the foregoing embodiment.

For another example, the first target sub-pixel, the third target sub-pixel, the second target sub-pixel, and the fourth target sub-pixel may be respectively the sub-pixel B, the sub-pixel C, the sub-pixel E, and the sub-pixel F in the foregoing embodiment. In this case, the first quadrilateral may be the quadrilateral BCEF in the foregoing embodiment.

For example, if the first sub-pixel column is the sub-pixel column 0, the second sub-pixel column is the sub-pixel column 2.

For another example, if the first sub-pixel column is the sub-pixel column 2, the second sub-pixel column is the sub-pixel column 4.

In some embodiments, an acute angle in internal angles of the first quadrilateral is greater than or equal to 80 degrees and less than or equal to 88 degrees.

For example, if the first target sub-pixel, the third target sub-pixel, the second target sub-pixel, and the fourth target sub-pixel are respectively the sub-pixel A, the sub-pixel B, the sub-pixel D, and the sub-pixel E in the foregoing embodiment, the acute angle may be an angle ADE and an angle ABE. If the first target sub-pixel, the third target sub-pixel, the second target sub-pixel, and the fourth target sub-pixel are respectively the sub-pixel B, the sub-pixel C, the sub-pixel E, and the sub-pixel F in the foregoing embodiment, the acute angle may be an angle EFC and an angle CBE.

In some embodiments, the first quadrilateral includes a fifth target sub-pixel, and the fifth target sub-pixel is a sub-pixel in the second sub-pixel row. When the fifth target sub-pixel is the second sub-pixel, a distance between coordinates of a center of the fifth target sub-pixel and a center of the first parallel quadrilateral is less than a first threshold; or when the fifth target sub-pixel is the third sub-pixel, a distance between coordinates of a center of the fifth target sub-pixel and a center of the first parallel quadrilateral is greater than a second threshold.

In some embodiments, when the fifth target sub-pixel is the third sub-pixel, a distance between the center of the fifth target sub-pixel and a long diagonal of the first quadrilateral is less than a third threshold.

For example, if the first quadrilateral is the quadrilateral ABDE shown in FIG. 3, the fifth target sub-pixel is a sub-pixel y in the quadrilateral ABDE; or if the first quadrilateral is the quadrilateral BCEF shown in FIG. 3, the fifth target sub-pixel is a sub-pixel z in the quadrilateral BCEF.

In some embodiments, the N rows of sub-pixels further include a fourth sub-pixel row, the first sub-pixel row, the second sub-pixel row, and the fourth sub-pixel row are three adjacent rows of sub-pixels in the N rows of sub-pixels, and the first sub-pixel row is located between the second sub-pixel row and the fourth sub-pixel row. The second sub-pixel and the third sub-pixel are alternately arranged in the fourth sub-pixel row. A connection line of a center of a sixth target sub-pixel, a center of a seventh target sub-pixel, a center of an eighth target sub-pixel, and a center of a ninth target sub-pixel forms a second quadrilateral. The second quadrilateral is a non-parallel quadrilateral. The sixth target sub-pixel and the seventh target sub-pixel are two adjacent sub-pixels in the second sub-pixel row. The eighth target sub-pixel and the ninth target sub-pixel are two adjacent sub-pixels in the fourth sub-pixel row. The sixth target sub-pixel and the eighth target sub-pixel belong to a third sub-pixel column. The seventh target sub-pixel and the ninth target sub-pixel belong to a fourth sub-pixel column. The third sub-pixel column and the fourth sub-pixel column are two adjacent columns of sub-pixels in the M columns of sub-pixels.

For example, the first sub-pixel row, the second sub-pixel row, and the fourth sub-pixel row may be respectively the sub-pixel row 2, the sub-pixel row 1, and the sub-pixel row 3. For another example, the first sub-pixel row, the second sub-pixel row, and the third sub-pixel row may be respectively the sub-pixel row 4, the sub-pixel row 3, and the sub-pixel row 5. The third sub-pixel column and the fourth sub-pixel column may be the sub-pixel column 1 and the sub-pixel column 3, or may be respectively the sub-pixel column 3 and the sub-pixel column 5, or may be respectively the sub-pixel column 5 and the sub-pixel column 7.

If the first sub-pixel row, the second sub-pixel row, and the fourth sub-pixel row are respectively the sub-pixel row 2, the sub-pixel row 1, and the sub-pixel row 3, the sixth target sub-pixel, the seventh target sub-pixel, the eighth target sub-pixel, and the ninth target sub-pixel may be respectively the sub-pixel 11, the sub-pixel 13, the sub-pixel 31, and the sub-pixel 33; or the sixth target sub-pixel, the seventh target sub-pixel, the eighth target sub-pixel, and the ninth target sub-pixel may be respectively the sub-pixel 13, the sub-pixel 15, the sub-pixel 33, and the sub-pixel 35.

In some embodiments, the center of the sixth target sub-pixel, the center of the seventh target sub-pixel, a center of a tenth target sub-pixel, and a center of an eleventh target sub-pixel form a third quadrilateral. The third quadrilateral is a parallel quadrilateral. The sixth target sub-pixel, the seventh target sub-pixel, and the tenth target sub-pixel are three adjacent sub-pixels in the second sub-pixel row. The eighth target sub-pixel, the ninth target sub-pixel, and the eleventh target sub-pixel are three adjacent sub-pixels in the fourth sub-pixel row. The tenth target sub-pixel and the eleventh target sub-pixel belong to a fifth sub-pixel column. The third sub-pixel column, the fourth sub-pixel column, and the fifth sub-pixel column are three columns of sub-pixels in the M columns of sub-pixels, and the fourth sub-pixel column is located between the third sub-pixel column and the fifth sub-pixel column.

For example, if the sixth target sub-pixel, the seventh target sub-pixel, the eighth target sub-pixel, and the ninth target sub-pixel are respectively the sub-pixel 11, the sub-pixel 13, the sub-pixel 31, and the sub-pixel 33, the tenth target sub-pixel and the eleventh target sub-pixel may be respectively the sub-pixel 15 and the sub-pixel 35. Correspondingly, the third sub-pixel column, the fourth sub-pixel column, and the fifth sub-pixel column are respectively the sub-pixel column 1, the sub-pixel column 3, and the sub-pixel column 5.

For another example, if the sixth target sub-pixel, the seventh target sub-pixel, the eighth target sub-pixel, and the ninth target sub-pixel are respectively the sub-pixel 13, the sub-pixel 15, the sub-pixel 33, and the sub-pixel 35, the tenth target sub-pixel and the eleventh target sub-pixel may be respectively the sub-pixel 17 and the sub-pixel 37. Correspondingly, the third sub-pixel column, the fourth sub-pixel column, and the fifth sub-pixel column are respectively the sub-pixel column 3, the sub-pixel column 5, and the sub-pixel column 7.

In some embodiments, an area of the second sub-pixel is greater than an area of the first sub-pixel, and the area of the second sub-pixel is greater than an area of the third sub-pixel.

In some embodiments, the first sub-pixel, the second sub-pixel, and the third sub-pixel are configured to emit light of different colors.

In some embodiments, the first sub-pixel is configured to emit green light, the second sub-pixel is configured to emit blue light, and the third sub-pixel is configured to emit red light.

In some embodiments, a shape of the first sub-pixel is a polygon, an ellipse, a circle, or a rounded polygon; a shape of the second sub-pixel is the polygon, the ellipse, the circle, or the rounded polygon; and a shape of the third sub-pixel is the polygon, the ellipse, the circle, or the rounded polygon.

An embodiment of this application further provides a display panel. The display panel includes the pixel arrangement structure in the foregoing embodiment.

An embodiment of this application further provides an electronic device. The electronic device includes a display panel, and the display panel includes the pixel arrangement structure in the foregoing embodiment.

An embodiment of this application further provides a preparation method for a display panel. The method includes: setting multiple sub-pixels on a substrate, where the multiple sub-pixels have the pixel arrangement structure in the foregoing embodiment.

A specific manufacturing process of the display panel is not limited in embodiments of this application, provided that the manufacturing process can protect the display panel of the pixel arrangement structure in the foregoing embodiment.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein.

In the several embodiments provided in this application, it should be understood that the disclosed system, apparatus, and method may be implemented in other manners. For example, the described apparatus embodiment is merely an example. For example, the unit division is merely logical function division and may be other division in actual implementation. For example, multiple units or assemblies may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate components may or may not be physically separate, and components displayed as units may or may not be physical units, may be located in one position, or may be distributed on multiple network units. Some or all of the units may be selected based on actual requirements to achieve the objectives of the solutions of embodiments.

In addition, functional units in embodiments of this application may be integrated into one processing unit, each of the units may exist alone physically, or two or more units may be integrated into one unit.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A pixel arrangement structure, wherein the pixel arrangement structure comprises sub-pixels arranged into a structure of N rows and M columns, and both N and M are positive integers greater than or equal to 3;
a first sub-pixel row, a second sub-pixel row, and a third sub-pixel row are three adjacent rows of sub-pixels in N rows of sub-pixels, and the second sub-pixel row is located between the first sub-pixel row and the third sub-pixel row;
a first sub-pixel, a second sub-pixel, and a third sub-pixel are three adjacent sub-pixels in the first sub-pixel row;
a fourth sub-pixel, a fifth sub-pixel, and a sixth sub-pixel are three adjacent sub-pixels in the third sub-pixel row;
the first sub-pixel and the fourth sub-pixel belong to a first sub-pixel column, the second sub-pixel and the fifth sub-pixel belong to a second sub-pixel column, the third sub-pixel and the sixth sub-pixel belong to a third sub-pixel column, the first sub-pixel column, the second sub-pixel column, and the third sub-pixel column are three columns of sub-pixels in M columns of sub-pixels, and the second sub-pixel column is located between the first sub-pixel column and the third sub-pixel column; and
a center of the first sub-pixel, a center of the second sub-pixel, a center of the third sub-pixel, a center of the fourth sub-pixel, a center of the fifth sub-pixel, and a center of the sixth sub-pixel form a virtual hexagon, and the virtual hexagon comprises at least three obtuse angles and at least two acute angles.

2. The pixel arrangement structure according to claim 1, wherein the first sub-pixel, the second sub-pixel, the third sub-pixel, the fourth sub-pixel, the fifth sub-pixel, and the sixth sub-pixel are configured to emit light of a first color.

3. The pixel arrangement structure according to claim 2, wherein a side length of a first side of the virtual hexagon is equal to a side length of a second side of the virtual hexagon, a side length of a third side of the virtual hexagon is equal to a side length of a fourth side of the virtual hexagon, endpoints of the first side are the center of the first sub-pixel and the center of the second sub-pixel, endpoints of the second side are the center of the second sub-pixel and the center of the third sub-pixel, endpoints of the third side are the center of the fourth sub-pixel and the center of the fifth sub-pixel, and endpoints of the fourth side are the center of the fifth sub-pixel and the center of the sixth sub-pixel.

4. The pixel arrangement structure according to any one of claims 1 to 3, wherein the second sub-pixel row comprises a seventh sub-pixel and an eighth sub-pixel, a distance between a center of the seventh sub-pixel and a center of a first virtual quadrilateral is less than a first threshold, and the first virtual quadrilateral consists of the center of the first sub-pixel, the center of the second sub-pixel, the center of the fourth sub-pixel, and the center of the fifth sub-pixel; and
a distance between a center of the eighth sub-pixel and a center of a second virtual quadrilateral is greater than a second threshold, and the second virtual quadrilateral consists of the center of the second sub-pixel, the center of the third sub-pixel, the center of the fifth sub-pixel, and the center of the sixth sub-pixel.

5. The pixel arrangement structure according to claim 4, wherein a distance between the center of the eighth sub-pixel and a long diagonal of the second virtual quadrilateral is less than a third threshold.

6. The pixel arrangement structure according to claim 4 or 5, wherein the seventh sub-pixel is configured to emit light of a second color, and the eighth sub-pixel is configured to emit light of a third color.

7. The pixel arrangement structure according to claim 1, wherein the first sub-pixel, the third sub-pixel, and the fifth sub-pixel are configured to emit light of a second color; and
the second sub-pixel, the fourth sub-pixel, and the sixth sub-pixel are configured to emit light of a third color.

8. The pixel arrangement structure according to any one of claims 1 to 7, wherein the at least two acute angles comprise acute angles greater than or equal to 80 degrees and less than or equal to 88 degrees.

9. The pixel arrangement structure according to claim 2, wherein the first color is green.

10. The pixel arrangement structure according to claim 6 or 7, wherein the second color is blue and the third pixel is red.

11. The pixel arrangement structure according to claim 10, wherein an area of a pixel configured to emit blue light is greater than an area of a pixel configured to emit red light, and the area of the pixel configured to emit blue light is greater than an area of a pixel configured to emit green light.

12. The pixel arrangement structure according to any one of claims 1 to 11, wherein a shape of each sub-pixel in the pixel arrangement structure is a polygon, an ellipse, a circle, or a rounded polygon.

13. A pixel arrangement structure, wherein the pixel arrangement structure comprises sub-pixels arranged into a structure of N rows and M columns, and both N and M are positive integers greater than or equal to 3; and
N rows of sub-pixels comprise a first sub-pixel row and a second sub-pixel row, and the first sub-pixel row and the second sub-pixel row are two adjacent rows of sub-pixels in the N rows of sub-pixels, wherein
P₁ groups of sub-pixels are arranged in the first sub-pixel row, each group of sub-pixels in the P₁ groups of sub-pixels comprises multiple first sub-pixels, the P₁ groups of sub-pixels one-to-one correspond to P₁ virtual straight lines, centers of the multiple first sub-pixels comprised in each group of sub-pixels in the P₁ groups of sub-pixels are located on a corresponding virtual straight line, any two virtual straight lines in the P₁ virtual straight lines are parallel, and P₁ is a positive integer greater than or equal to 2; and
a second sub-pixel and a third sub-pixel are alternately arranged in the second sub-pixel row.

14. The pixel arrangement structure according to claim 13, wherein the second sub-pixel row comprises P₂ groups of sub-pixels, each group of sub-pixels in the P₁ groups of sub-pixels comprises multiple sub-pixels, the P₂ groups of sub-pixels one-to-one correspond to P₂ virtual straight lines, centers of the multiple sub-pixels comprised in each group of sub-pixels in the P₂ groups of sub-pixels are located on a corresponding virtual straight line, any two virtual straight lines in the P₂ virtual straight lines are parallel, and P₂ is a positive integer greater than or equal to 2.

15. The pixel arrangement structure according to claim 13 or 14, wherein the N rows of sub-pixels further comprise a third sub-pixel row, the first sub-pixel row, the second sub-pixel row, and the third sub-pixel row are three adjacent rows of sub-pixels in the N rows of sub-pixels, and the second sub-pixel row is located between the first sub-pixel row and the third sub-pixel row, wherein
P₃ groups of sub-pixels are arranged in the third sub-pixel row, each group of sub-pixels in the P₃ groups of sub-pixels comprises multiple first sub-pixels, the P₃ groups of sub-pixels one-to-one correspond to P₃ virtual straight lines, centers of the multiple first sub-pixels comprised in each group of sub-pixels in the P₃ groups of sub-pixels are located on a corresponding virtual straight line, any two virtual straight lines in the P₃ virtual straight lines are parallel, and P₃ is a positive integer greater than or equal to 2; and
a center of a first target sub-pixel and a center of a second target sub-pixel are respectively located on two parallel virtual straight lines, wherein the first target sub-pixel is a sub-pixel in the first sub-pixel row, the second target sub-pixel is a sub-pixel in the third sub-pixel row, the first target sub-pixel and the second target sub-pixel belong to a first sub-pixel column, and the first sub-pixel column is one column of sub-pixels in M columns of sub-pixels.

16. The pixel arrangement structure according to claim 15, wherein a connection line of a center of a third target sub-pixel, a center of a fourth target sub-pixel, the center of the first target sub-pixel, and the center of the second target sub-pixel forms a first quadrilateral, the first quadrilateral is a parallel quadrilateral, the third target pixel is a sub-pixel that is adjacent to the first target sub-pixel and that is in the first sub-pixel row, the fourth target sub-pixel is a sub-pixel that is adjacent to the second target sub-pixel and that is in the third sub-pixel row, the third target pixel and the fourth target pixel belong to a second sub-pixel column, and the second sub-pixel column and the first sub-pixel column are two columns of sub-pixels in the M columns of sub-pixels.

17. The pixel arrangement structure according to claim 16, wherein an acute angle in internal angles of the first quadrilateral is greater than or equal to 80 degrees and less than or equal to 88 degrees.

18. The pixel arrangement structure according to claim 16 or 17, wherein the first quadrilateral comprises a fifth target sub-pixel, and the fifth target sub-pixel is a sub-pixel in the second sub-pixel row; and
when the fifth target sub-pixel is the second sub-pixel, a distance between coordinates of a center of the fifth target sub-pixel and a center of the first parallel quadrilateral is less than a first threshold; or
when the fifth target sub-pixel is the third sub-pixel, a distance between coordinates of a center of the fifth target sub-pixel and a center of the first parallel quadrilateral is greater than a second threshold.

19. The pixel arrangement structure according to claim 18, wherein when the fifth target sub-pixel is the third sub-pixel, a distance between the center of the fifth target sub-pixel and a long diagonal of the first quadrilateral is less than a third threshold.

20. The pixel arrangement structure according to any one of claims 13 to 19, wherein the N rows of sub-pixels further comprise a fourth sub-pixel row, the first sub-pixel row, the second sub-pixel row, and the fourth sub-pixel row are three adjacent rows of sub-pixels in the N rows of sub-pixels, and the first sub-pixel row is located between the second sub-pixel row and the fourth sub-pixel row, wherein
the second sub-pixel and the third sub-pixel are alternately arranged in the fourth sub-pixel row; and
a connection line of a center of a sixth target sub-pixel, a center of a seventh target sub-pixel, a center of an eighth target sub-pixel, and a center of a ninth target sub-pixel forms a second quadrilateral, wherein
the second quadrilateral is a non-parallel quadrilateral;
the sixth target sub-pixel and the seventh target sub-pixel are two adjacent sub-pixels in the second sub-pixel row;
the eighth target sub-pixel and the ninth target sub-pixel are two adjacent sub-pixels in the fourth sub-pixel row;
the sixth target sub-pixel and the eighth target sub-pixel belong to a third sub-pixel column;
the seventh target sub-pixel and the ninth target sub-pixel belong to a fourth sub-pixel column; and
the third sub-pixel column and the fourth sub-pixel column are two columns of sub-pixels in the M columns of sub-pixels.

21. The pixel arrangement structure according to claim 20, wherein the center of the sixth target sub-pixel, the center of the seventh target sub-pixel, a center of a tenth target sub-pixel, and a center of an eleventh target sub-pixel form a third quadrilateral, wherein
the third quadrilateral is a parallel quadrilateral;
the sixth target sub-pixel, the seventh target sub-pixel, and the tenth target sub-pixel are three adjacent sub-pixels in the second sub-pixel row;
the eighth target sub-pixel, the ninth target sub-pixel, and the eleventh target sub-pixel are three adjacent sub-pixels in the fourth sub-pixel row;
the tenth target sub-pixel and the eleventh target sub-pixel belong to a fifth sub-pixel column; and
the third sub-pixel column, the fourth sub-pixel column, and the fifth sub-pixel column are three columns of sub-pixels in the M columns of sub-pixels, and the fourth sub-pixel column is located between the third sub-pixel column and the fifth sub-pixel column.

22. The pixel arrangement structure according to any one of claims 13 to 21, wherein an area of the second sub-pixel is greater than an area of the first sub-pixel, and the area of the second sub-pixel is greater than an area of the third sub-pixel.

23. The pixel arrangement structure according to any one of claims 13 to 22, wherein the first sub-pixel, the second sub-pixel, and the third sub-pixel are configured to emit light of different colors.

24. The pixel arrangement structure according to claim 23, wherein the first sub-pixel is configured to emit green light, the second sub-pixel is configured to emit blue light, and the third sub-pixel is configured to emit red light.

25. The pixel arrangement structure according to any one of claims 13 to 24, wherein a shape of the first sub-pixel is a polygon, an ellipse, a circle, or a rounded polygon;
a shape of the second sub-pixel is the polygon, the ellipse, the circle, or the rounded polygon; and
a shape of the third sub-pixel is the polygon, the ellipse, the circle, or the rounded polygon.

26. A display panel, wherein the display panel comprises the pixel arrangement structure according to any one of claims 1 to 25.

27. An electronic device, wherein the electronic device comprises the display panel according to claim 26.

28. A preparation method for a display panel, wherein multiple sub-pixels are set on a substrate, and the multiple sub-pixels have the pixel arrangement structure according to any one of claims 1 to 25.
